# DEMANDE DE BREVET EUROPEEN

(11) **EP 3 511 293 A1**
(43) Date de publication de la demande: **17.07.2019**
(21) Numéro de dépôt: 18306759.4
(22) Date de dépôt: 20.12.2018
(51) Int. Cl.: B82Y 10/00, H01L 29/417, H01L 29/775, H01L 29/06, H01L 29/08, H01L 29/40, H01L 21/336

(54) **PROCEDE DE FABRICATION D'AU MOINS UN TRANSISTOR A EFFET DE CHAMP**

(30) Priorité: 29.12.2017 US 201715858266
(71) Demandeur: Commissariat à l'Énergie Atomique et aux Énergies Alternatives, 75015 Paris (FR); International Business Machines Corporation, Yorktown Heights, NY 10598 (US)
(72) Inventeur: REBOH, Shay, 38054 GRENOBLE CEDEX 09 (FR); AUGENDRE, Emmanuel, 38330 MONTBONNOT (FR); COQUAND, Rémi, 73800 Les Marches (FR); LOUBET, Nicolas, GUILDERLAND, NY New York 12084 (US)
(74) Mandataire: GIE Innovation Competence Group

(57) **Abrégé**

Le procédé de fabrication d'au moins un transistor à effet de champ est tel qu'il comporte une étape de fourniture d'un substrat (1) surmonté de première, deuxième et troisième structures (100, 200, 300), la deuxième structure (200) étant agencée entre les première et troisième structures (100, 300). La deuxième structure (200) comprend au moins un premier nano-objet (201) situé à distance du substrat (1), une partie (201c) du premier nano-objet (201) étant destinée à former une zone de canal du transistor. Le procédé de fabrication comporte en outre une étape de formation d'électrodes (11, 12) du transistor comprenant : une étape de croissance par épitaxie d'un premier matériau d'où il résulte l'obtention d'une première continuité de matière (13) en premier matériau entre la deuxième structure (200) et la première structure (100), et l'obtention d'une deuxième continuité de matière (14) en premier matériau entre la deuxième structure (200) et la troisième structure (300) ; une étape de croissance par épitaxie d'un deuxième matériau, à partir du premier matériau des première et deuxième continuités de matière (13, 14), le deuxième matériau ayant un paramètre de maille différent du paramètre de maille du premier matériau des première et deuxième continuités de matière (13, 14).

## Description

### Domaine technique de l'invention

Le domaine technique de l'invention concerne les transistors à effet de champ, notamment à grille enrobante, et en particulier un procédé de fabrication d'au moins un tel transistor.

### Etat de la technique

Dans le domaine des transistors, il existe une configuration à grille enrobante aussi connue sous la dénomination anglo-saxonne « Gate-AII-Around » dont le sigle est GAA. Dans une telle configuration, l'électrode de grille du transistor entoure une zone de canal du transistor, notamment avec interposition d'un isolant de grille.

Un procédé de fabrication connu pour un transistor à effet de champ à grille enrobante de type pMOS (sigle de « P-Type Metal Oxyde Semiconductor » en langue anglaise) est le suivant. On forme, sur un substrat, un empilement de nanofils comprenant une alternance de nanofils de silicium et de nanofils de silicium-germanium (SiGe). Sur cet empilement, il est formé une grille sacrificielle, puis des espaceurs externes disposés de part et d'autre de la grille sacrificielle, de sorte à recouvrir une partie de l'empilement. La grille sacrificielle et les espaceurs externes sont formés grâce à des étapes de lithographie et de gravure adaptées de matériaux déposés. Les parties des nanofils de l'empilement qui s'étendent hors du recouvrement formé par la grille sacrificielle et les espaceurs externes sont retirées, par exemple par gravure. Les extrémités longitudinales des nanofils en silicium-germanium sont ensuite gravées horizontalement, c'est-à-dire selon leurs axes d'allongement de sorte à former des évidements qui sont ensuite comblés par un matériau isolant électrique pour former des espaceurs internes dont le rôle est, en collaboration avec les espaceurs externes, de séparer les futures électrodes de source et de drain de la future électrode de grille pour améliorer les performances du transistor en diminuant les capacités parasites. Ensuite, les électrodes de source et de drain sont formées par épitaxie dans la continuité des nanofils de silicium qui ont été conservés sous la grille sacrificielle et les espaceurs externes. Les électrodes de source et de drain sont ensuite encapsulées dans un matériau de passivation ou d'encapsulation. Ensuite, la grille sacrificielle est retirée pour révéler des parties des nanofils entre les espaceurs externes. Par une gravure sélective, le reste des nanofils de SiGe est retiré. Ensuite, un isolant de grille est formé autour de chaque nanofil de silicium selon son axe d'allongement, puis un matériau de grille est déposé de sorte à former une électrode de grille entourant les nanofils de silicium selon leur axe d'allongement.

Il est connu qu'une contrainte en tension de la zone de canal d'un transistor est bénéfique pour les transistors de type nMOS (sigle de « N-Type Metal Oxyde Semiconductor » en langue anglaise) mais est problématique pour les transistors de type pMOS, pour lesquels une contrainte en compression de la zone de canal est recherchée. Le procédé de fabrication décrit ci-dessus ne permet pas d'introduire de manière significative une contrainte en tension ou en compression dans la zone de canal. Il en résulte un besoin de trouver une solution permettant d'obtenir un transistor dont la zone de canal est volontairement contrainte, selon le cas recherché nMOS ou pMOS, en tension ou en compression.

### Objet de l'invention

L'invention a pour but un procédé de fabrication d'au moins un transistor dont une partie est destinée à former une zone de canal du transistor contrainte de manière adaptée.

On tend vers ce but grâce à un procédé de fabrication d'au moins un transistor à effet de champ, ce procédé de fabrication comportant :
- une étape de fourniture d'un substrat surmonté de première, deuxième et troisième structures, la deuxième structure étant agencée entre les première et troisième structures, la deuxième structure comprenant au moins un premier nano-objet situé à distance du substrat, une partie du premier nano-objet de la deuxième structure étant destinée à former une zone de canal du transistor, le premier nano-objet comportant des première et deuxième extrémités opposées selon un axe de référence passant par lesdites première et deuxième extrémités,
- une étape de formation d'électrodes du transistor comprenant :
   ∘ une étape de croissance par épitaxie d'un premier matériau d'où il résulte l'obtention d'une première continuité de matière en premier matériau reliant, selon l'axe de référence, la première extrémité du premier nano-objet de la deuxième structure à la première structure, et l'obtention d'une deuxième continuité de matière en premier matériau reliant, selon l'axe de référence, la deuxième extrémité du premier nano-objet de la deuxième structure à la troisième structure,
   ∘ une étape de croissance par épitaxie d'un deuxième matériau, à partir du premier matériau des première et deuxième continuités de matière, le deuxième matériau ayant un paramètre de maille différent du paramètre de maille du premier matériau des première et deuxième continuités de matière d'où il résulte que le deuxième matériau est contraint.

Un tel procédé de fabrication présente l'avantage de mettre sous contrainte adaptée la zone de canal en utilisant des structures, disposées de part et d'autre de la zone de canal, et des électrodes, constituant généralement les électrodes de source et de drain reliées à la zone de canal.

Le procédé de fabrication peut comporter une ou plusieurs des caractéristiques suivantes :
- l'étape de croissance par épitaxie du premier matériau est mise en oeuvre au moins depuis les première, deuxième et troisième structures ;
- le procédé de fabrication comporte une étape de formation d'un masque de croissance pour former des espaces de confinement dans lesquels la croissance par épitaxie du premier matériau est réalisée, et une étape de retrait du masque de croissance avant de mettre en oeuvrel'étape de croissance par épitaxie du deuxième matériau ;
- l'étape croissance par épitaxie du premier matériau est telle que ladite croissance du premier matériau est aussi réalisée depuis le substrat, notamment depuis une première zone libre du substrat située entre les première et deuxième structures et depuis une deuxième zone libre du substrat située entre les deuxième et troisième structures ;
- l'étape de formation d'électrodes comporte :
   - une étape de formation de protections agencées dans le prolongement des première et deuxième continuités de matière, les première et deuxième continuités de matière étant chacune agencée entre l'une des protections et le substrat, puis
   - une étape de gravure latérale du premier matériau de sorte à affiner les première et deuxième continuités de matière avant de mettre en oeuvre l'étape de croissance par épitaxie du deuxième matériau ;
- l'étape de formation des protections est réalisée après l'étape de retrait du masque de croissance et avant l'étape de croissance par épitaxie du deuxième matériau ;
- l'étape de gravure latérale permet de découvrir :
   - de part et d'autre de la première continuité de matière, des portions de la première extrémité du premier nano-objet de la deuxième structure,
   - de part et d'autre de la deuxième continuité de matière, des portions de la deuxième extrémité du premier nano-objet de la deuxième structure ;
- après l'étape de gravure latérale :
   - l'étape de croissance par épitaxie du deuxième matériau est réalisée alors que les protections sont présentes, ou
   - le procédé de fabrication comporte une étape de retrait des protections avant de réaliser l'étape de croissance par épitaxie du deuxième matériau ;
- l'étape de croissance par épitaxie du premier matériau se fait depuis les première, deuxième et troisième structures et de telle sorte que :
   - entre les première et deuxième structures, le premier matériau croît d'une part, depuis la première structure vers la deuxième structure, et, d'autre part, depuis la deuxième structure vers la première structure d'où il résulte la présence de deux fronts de croissance entre les première et deuxième structures,
   - entre les deuxième et troisième structures, le premier matériau croît d'une part, depuis la troisième structure vers la deuxième structure, et, d'autre part, depuis la deuxième structure vers la troisième structure d'où il résulte la présence de deux fronts de croissance entre les deuxième et troisième structures,
   l'étape de croissance par épitaxie du premier matériau étant stoppé consécutivement à la mise en contact des fronts de croissance entre les première et deuxième structures et des fronts de croissance entre les deuxième et troisième structures ;
- le substrat est tel qu'il présente, avant la mise en oeuvrede l'étape de croissance par épitaxie du premier matériau, une première zone libre reliant la première structure à la deuxième structure et une deuxième zone libre reliant la deuxième structure à la troisième structure, les première et deuxième zones libres étant en matériau diélectrique depuis lequel la croissance par épitaxie du premier matériau est inhibée ;
- le premier matériau, de préférence dopé, est du silicium ou du silicium-germanium, et le deuxième matériau, de préférence dopé, est du silicium-germanium ;
- le premier matériau est du Si(₁₋ₓ)Geₓ ou du Si, et le deuxième matériau est du Si(_{i-y})Ge_{y} , avec x>0, y>0 et x étant strictement inférieur à y ;
- le procédé de fabrication comporte, après l'étape de croissance par épitaxie du deuxième matériau, une étape de recuit ;
- le procédé de fabrication comporte une étape de formation d'une électrode de grille du transistor qui entoure, de préférence avec interposition d'un isolant de grille, la partie du premier nano-objet issue de la deuxième structure et destinée à former la zone de canal du transistor ;
- l'étape de fourniture est telle que :
   - la deuxième structure comporte des deuxièmes nano-objets sacrificiels, et le premier nano-objet de la deuxième structure est agencé entre, et en contact avec, deux deuxièmes nano-objets de la deuxième structure pour former un empilement de nano-objets, et
   - une partie intermédiaire dudit empilement de nano-objets est recouverte par une grille sacrificielle située entre des premier et deuxième espaceurs recouvrant des parties d'extrémité dudit empilement situées de part et d'autre de la partie intermédiaire, les première et deuxième extrémités opposées dudit premier nano-objet de l'empilement de nano-objets étant accessibles au niveau des premier et deuxième espaceurs ;
- avant de former l'électrode de grille du transistor, le procédé de fabrication comporte une étape de retrait de la grille sacrificielle et une étape de gravure des deuxièmes nano-objets rendus accessibles par le retrait de la grille sacrificielle pour libérer ladite partie du premier nano-objet de la deuxième structure destinée à former la zone de canal du transistor, ensuite l'étape de formation de l'électrode de grille permet de former ladite électrode de grille entre les premier et deuxième espaceurs.

L'invention est aussi relative à un dispositif électronique comportant au moins un transistor, un substrat surmonté de premier, deuxième et troisième éléments, le deuxième élément étant agencé entre les premier et troisième éléments, le deuxième élément comportant au moins un nano-objet et le transistor étant muni d'une zone de canal formée par une partie dudit nano-objet, ledit nano-objet comprenant des première et deuxième extrémités opposées selon un axe de référence passant par les première et deuxième extrémités, ledit dispositif électronique étant tel que :
- la première extrémité du nano-objet est reliée au premier élément par une première électrode du transistor, ladite première électrode comportant :
   ∘ une première partie formant une première continuité de matière entre ladite première extrémité et le premier élément,
   ∘ une deuxième partie formée sur ladite première partie,
- la deuxième extrémité du nano-objet est reliée au troisième élément par une deuxième électrode du transistor, ladite deuxième électrode comportant :
   ∘ une première partie formant une deuxième continuité de matière entre ladite deuxième extrémité et le troisième élément,
   ∘ une deuxième partie formée sur ladite première partie,
les premières parties des première et deuxième électrodes étant formées en un premier matériau et les deuxième parties des première et deuxième électrodes étant formées en un deuxième matériau, le paramètre de maille du deuxième matériau s'étant adapté à celui du premier matériau de sorte à induire une contrainte dans le nano-objet selon l'axe de référence.

### Description sommaire des figures

L'invention sera mieux comprise à la lecture de la description qui va suivre de modes de réalisation particuliers de l'invention, donnée uniquement à titre d'exemple non limitatif et faite en se référant aux dessins sur lesquels :
- La figure 1 illustre une vue en perspective présentant un état du transistor au cours de son procédé de fabrication,
- La figure 2 est une vue en coupe de la figure 1,
- Les figures 3 à 6 illustrent des étapes du procédé de fabrication permettant notamment d'obtenir ce qui est représenté en figures 1 et 2,
- Les figures 7 à 11 illustrent des étapes d'un mode de réalisation du procédé de fabrication, la figure 8 étant une vue en coupe de la figure 7 et la figure 10 une vue en coupe de la figure 9,
- Les figures 12 à 15 illustrent des étapes d'un autre mode de réalisation du procédé de fabrication selon des vues en perspective,
- Les figures 16 à 19 illustrent des étapes d'encore un autre mode de réalisation du procédé de fabrication selon des vues en perspective,
- Les figures 20 et 21 représentent des vues en coupe permettant d'illustrer la formation d'espaceurs internes du transistor,
- Les figures 22 et 23 représentent des vues en coupes permettant d'illustrer la formation d'au moins une électrode de grille du transistor.

Dans ces figures, les mêmes références sont utilisées pour désigner les mêmes éléments.

Par ailleurs, pour des raisons de compréhension des figures, les éléments représentés sur les différentes figures sont schématiques, et ne sont pas nécessairement représentés selon une échelle uniforme.

### Description de modes particuliers de réalisation

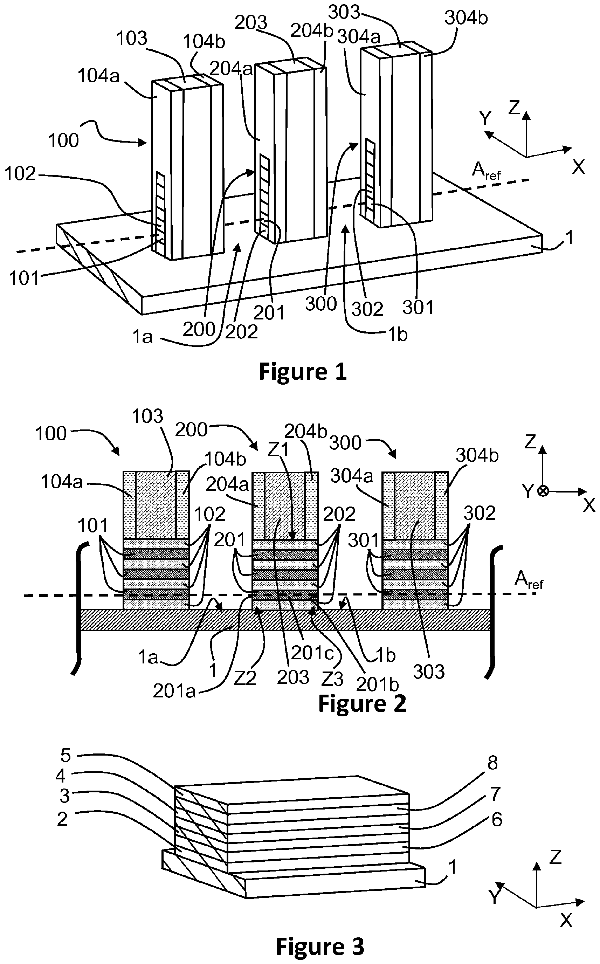

Dans la présente description, les termes qui dépendent de l'orientation, tel que « au-dessus », « latéral » s'appliquent en considérant l'orientation représentée aux figures selon le repère orthogonal d'axes X, Y, Z, avec Z pointant vers le haut. Les axes de ce repère sont deux à deux orthogonaux. En particulier, sauf stipulation contraire, une épaisseur est mesurée selon une direction parallèle à l'axe Z, une longueur est mesurée selon une direction parallèle à l'axe X, une dimension latérale est mesurée selon une direction parallèle à l'axe Y, et une hauteur est mesurée selon une direction parallèle à l'axe Z. Le plan défini par les axes X, Y est un plan parallèle au substrat décrit ci-après. Les plans de coupe des figures 2, 8, 10, 20, 21, 22, 23 sont donnés selon des plans parallèles au plan défini par les axes X, Z. Une mesure, ou une dimension, selon un axe ou une direction, peut être réalisée, ou donnée, parallèlement à cet axe ou à cette direction.

Dans la présente description, le terme « parallèle » peut être remplacé par « sensiblement parallèle » dans la mesure où des tolérances sont acceptées dans le domaine.

Dans la présente description, le terme « orthogonal » peut être remplacé par « sensiblement orthogonal » dans la mesure où des tolérances sont acceptées dans le domaine.

Dans la présente description, par « à base de », on entend « comporte majoritairement ».

Dans la présente description, lorsque deux valeurs sont comprises entre deux bornes, les bornes sont incluses.

Dans la présente description, le terme nano-objet peut correspondre à un élément de forme allongée quelle que soit la forme du profil de sa section transversale. Des dimensions du nano-objet sont décrites ci-après. De manière plus générale, le terme nano-objet désigne tout aussi bien un nanofil, une nanoplaque ou un nanobarreau. Si le nano-objet est un nanofil, ses première et deuxième extrémités opposées telles que décrites ci-après sont préférentiellement des extrémités longitudinales opposées.

Dans la présente description, une contrainte selon un axe est une contrainte donnée le long de cet axe ou parallèlement à cet axe.

Dans la présente description, un paramètre de maille d'un matériau à l'état relaxé correspond à sa valeur lorsqu'il est à l'état naturel non contraint. Un paramètre de maille d'un matériau donné formant une chose, comme par exemple une continuité de matière ou une partie d'électrode, correspond à la valeur effective du paramètre de maille du matériau donné au sein de cette chose, cette valeur peut être différente de celle du matériau donné à l'état relaxé si le matériau donné de ladite chose est contraint, ou peut être égale à celle du matériau donné à l'état relaxé si le matériau donné est à l'état relaxé.

La présente invention propose d'ancrer une structure donnée, destinée à participer à la formation d'un transistor, à deux autres structures. Cet ancrage est utilisé pour induire une contrainte en tension, ou en compression, dans une zone de canal du futur transistor formée dans ladite structure donnée grâce à des étapes de croissance adaptées, notamment par épitaxie, de deux électrodes réalisées simultanément et en deux temps, ces deux électrodes étant notamment des électrodes de source et de drain du transistor.

Une contrainte au sens de la présente description est une contrainte mécanique qui peut être en tension ou en compression de préférence selon un axe d'un nano-objet dont une partie est destinée à former la zone de canal de transistor. L'axe du nano-objet s'étend ici entre deux extrémités opposées du nano-objet destinées à être reliées respectivement à une électrode de source et une électrode de drain.

Un axe de référence au sens de la présente description est un axe passant par des première et deuxième extrémités opposées d'un nano-objet correspondant destinées à être reliées à des électrodes, notamment aux électrodes de source et de drain du transistor. Cet axe de référence peut être vu comme l'axe évoqué ci-dessus du nano-objet. Lorsque l'axe de référence est représenté aux figures, il l'est en pointillé selon la référence A_{ref}.

Le procédé de fabrication d'au moins un transistor à effet de champ, notamment à électrode de grille enrobante, comporte, comme illustré en figures 1 et 2, une étape de fourniture d'un substrat 1 surmonté d'une première structure 100, d'une deuxième structure 200 et d'une troisième structure 300. Ces première à troisième structures 100, 200, 300 sont notamment fixées au substrat 1. La deuxième structure 200 est agencée entre les première et troisième structures 100, 300. La deuxième structure 200, et de préférence chacune des première, deuxième et troisième structure 100, 200, 300, comporte au moins un nano-objet 101, 201, 301, généralement appelé « premier nano-objet» dans la suite de la description, situé à distance du substrat 1. Par « au moins un premier nano-objet », on entend que la structure correspondante peut comporter un premier nano-objet ou plusieurs premiers nano-objets. Autrement dit, pour une structure donnée, tout ce qui s'applique à un premier nano-objet de la structure donnée peut s'appliquer à plusieurs premiers nano-objets, et notamment à chaque premier nano-objet, de cette structure donnée. Par « situé à distance du substrat 1 », on entend que le premier nano-objet 101, 201, 301 n'est pas en contact direct avec le substrat 1, ceci est notamment nécessaire pour permettre de réaliser ultérieurement une électrode de grille enrobante, c'est-à-dire entourant une partie 201c de premier nano-objet 201. La partie 201c du premier nano-objet 201 de la deuxième structure 200 est destinée à former une zone de canal du transistor, cette partie 201c est située entre des première et deuxième extrémités 201a, 201 b opposées dudit premier nano-objet 201. Ces première et deuxième extrémités 201a, 201b sont opposées selon l'axe de référence A_{ref} passant par lesdites première et deuxième extrémités 201a, 201b. Le cas échéant, une partie du premier nano-objet 101 de la première structure 100 est destinée à former une zone de canal d'un autre transistor et une partie du premier nano-objet 301 de la troisième structure 300 est destinée à former une zone de canal d'encore un autre transistor. La zone de canal - aussi appelée région de canal dans le domaine - pour un premier nano-objet correspond à un tronçon, ou partie, du premier nano-objet qui sera entouré, ou selon une autre formulation enrobé, par l'électrode de grille correspondante du transistor. Notamment, un isolant de grille est interposé entre l'électrode de grille et la zone de canal. On comprend alors que selon les cas, chaque transistor peut comporter une ou plusieurs zones de canal, chaque zone de canal étant alors formée par une partie d'un premier nano-objet correspondant. Le cas échéant, dans la présente description, une structure peut être selon le contexte l'une des première à troisième structures.

Comme illustré aux figures 1 et 2, les première à troisième structures 100, 200, 300 sont alignées. On dit que les première et deuxième structures 100, 200 sont adjacentes et séparées par un espace vide qui sera ensuite comblé au moins partiellement pour y former une électrode du transistor (le cas échéant l'électrode de source ou l'électrode de drain) qui sera formée au moins à partir de (c'est-à-dire notamment au moins depuis) la deuxième structure 200. Par ailleurs, on dit que les deuxième et troisième structures 200, 300 sont adjacentes et séparées par un espace vide qui sera ensuite comblé au moins partiellement pour y former une autre électrode du transistor (le cas échéant l'électrode de drain ou l'électrode de source) qui sera formée au moins à partir de (c'est-à-dire notamment au moins depuis) la deuxième structure 200. Si les première et troisième structures 100, 300 sont aussi utilisées au cours du procédé de fabrication pour former des transistors, les électrodes formées entre les première et deuxième structures 100, 200, et entre les deuxième et troisième structure 200, 300, seront chacune commune à deux transistors adjacents. L'alignement des première à troisième structures 100, 200, 300 est notamment tel que l'axe de référence A_{ref} décrit ci-dessus passe par les première à troisième structures 100, 200, 300.

Les figures 1 et 2 représentent trois structures alignées, cependant, il peut être formé une pluralité de structures alignées identiques de sorte à former une ligne de structures en vue de former des transistors : il existe alors une ligne de structures. Dans ce cas, hors les structures situées aux extrémités de la ligne de structures qui pourront ne servir qu'à l'ancrage décrit ci-après, chacune des structures située entre les structures d'extrémité peut être utilisée pour former un transistor fonctionnel. Dans ce cas, deux transistors adjacents formés à partir de deux structures adjacentes peuvent partager une même électrode. En ce sens, chaque structure comprise entre les structures d'extrémité de la ligne de structures peut être traitée comme une deuxième structure au sens de la présente description et agencée entre des première et troisième structures qui lui sont immédiatement adjacentes. C'est notamment en ce sens que les figures 1 à 23 représentent au moins une partie d'un substrat tronqué sur sa gauche et sur sa droite dans le référentiel de ces figures : d'autres structures peuvent être formées sur le substrat de part et d'autre des première à troisième structures représentées.

Les structures, notamment les première à troisième structures peuvent être identiques, ou similaires, c'est-à-dire qu'elles comportent les mêmes éléments, notamment obtenus simultanément par des étapes technologiques de microélectronique.

De préférence (figures 1 et 2), le premier nano-objet 101 de la première structure 100 est aligné avec le premier nano-objet 201 correspondant de la deuxième structure 200 et avec le premier nano-objet 301 correspondant de la troisième structure 300. Selon une autre formulation, un triplet de premiers nano-objets 101, 201, 301 associés chacun à une structure différente peuvent s'étendre chacun selon un même axe (parallèle à l'axe X) par exemple représenté par l'axe de référence A_{ref} : des premiers nano-objets de deux structures adjacentes sont coaxiaux mais séparés selon ledit axe A_{ref} d'une distance prédéterminée, par exemple cette distance peut être comprise entre 10nm et 150nm. Selon encore une autre formulation, pour un triplet de premiers nano-objets 101, 201, 301 donnés, les nano-objets sont agencés dans le prolongement l'un de l'autre, et séparés l'un de l'autre par la distance prédéterminée : ils ne sont pas en contact direct.

En particulier, sur les figures 1 et 2, l'étape de fourniture du substrat 1 surmonté de première à troisième structures 100, 200, 300 peut être telle que la, ou au moins la, deuxième structure 200, et notamment chacune des première, deuxième et troisième structures 100, 200, 300 comporte des deuxièmes nano-objets 102, 202, 302. Autrement dit, tout ce qui s'applique dans la présente description à la deuxième structure 200 peut aussi s'appliquer aux première et troisième structures 100, 300 qui comportent les mêmes composants généralement formés simultanément lorsqu'ils sont de même type. Ces deuxièmes nano-objets 202 sont des deuxièmes nano-objets 202 sacrificiels, c'est-à-dire qu'ils sont destinés à être retirés au cours du procédé de fabrication du transistor. En ce sens, le premier nano-objet 201 de la deuxième structure 200 est agencé entre (notamment selon l'axe Z), et en contact avec, deux deuxièmes nano-objets 202 de la deuxième structure 200 pour former un empilement de nano-objets. L'empilement de nano-objets de la deuxième structure 200 est réalisé de telle sorte que des axes, notamment longitudinaux, desdits nano-objets de l'empilement soient parallèles entre eux mais décalés selon l'axe Z. Autrement dit, la hauteur de l'empilement selon la direction d'empilement des nano-objets peut être mesurée par rapport au substrat qui forme alors le point bas. Autrement dit, l'empilement de nano-objets s'élève au-dessus du substrat 1, c'est-à-dire que la direction d'empilement des nano-objets (premier(s) et deuxièmes nano-objets) est orthogonale au substrat. De préférence, l'étape de fourniture est aussi telle qu'une partie intermédiaire Z1 (figure 2) de l'empilement de nano-objets de la deuxième structure 200 est recouverte par une grille sacrificielle 203 de la deuxième structure 200. La grille sacrificielle 203 est située entre des premier et deuxième espaceurs 204a, 204b (aussi appelés dans le domaine espaceurs externes) de la deuxième structure 200. Ces premier et deuxième espaceurs 204a, 204b sont destinés à faire partie du transistor. La grille sacrificielle 203 peut s'étendre depuis le substrat 1. Les premier et deuxième espaceurs 204a, 204b de la deuxième structure 200 recouvrent des parties d'extrémité Z2, Z3 dudit empilement de nano-objets de la deuxième structure 200 situées de part et d'autre, et de préférence en continuité, de la partie intermédiaire Z1 de l'empilement de nano-objets de la deuxième structure 200. Les premier et deuxième espaceurs 204a, 204b de la deuxième structure 200 peuvent s'étendre depuis le substrat 1. Les première et deuxième extrémités 201a, 201b opposées du premier nano-objet 201 de l'empilement de nano-objets de la deuxième structure 200 sont accessibles au niveau des premier et deuxième espaceurs 204a, 204b de l'empilement de nano-objets correspondant. Par « première et deuxième extrémités opposées accessibles au niveau des premier et deuxième espaceurs », on entend que les premier et deuxième espaceurs 204a, 204b comportent chacun une face externe depuis laquelle est accessible l'une des première et deuxième extrémités 201a, 201b du premier nano-objet 201, ces faces externes étant orientées vers des directions opposées. La première structure 100 peut aussi comporter une grille sacrificielle 103, et des premier et deuxième espaceurs 104a, 104b. Par ailleurs, la troisième structure 300 peut aussi comporter une grille sacrificielle 303, et des premier et deuxième espaceurs 304a, 304b. La fabrication de ces structures comprenant des grilles sacrificielles et des espaceurs est connue en soi de l'homme du métier, et présente l'avantage de permettre la fabrication de transistors de type GAA. Notamment, les nano-objets, la grille sacrificielle et les premiers et deuxième espaceurs peuvent être gravés chacun sélectivement. Chaque grille sacrificielle 103, 203, 303 peut être formée en un matériau tel que le silicium ou le silicium-germanium, ce matériau étant amorphe ou polycristallin. Une grille sacrificielle au sens de la présente description peut présenter une dimension mesurée selon l'axe de référence A_{ref} (c'est-à-dire selon l'axe X) comprise entre 5nm et 150nm, une hauteur comprise entre 20nm et 200nm, et une dimension latérale adaptée aux besoins structurels. Les premier et deuxième espaceurs peuvent quant à eux chacun être formé en un matériau diélectrique tel que le SiN (nitrure de silicium) ou le SiBCN (nitrure de silicium-bore-carbone). Chacun des premier et deuxième espaceurs peut présenter une dimension mesurée selon l'axe de référence A_{ref} associé au premier nano-objet qu'il recouvre en partie comprise entre 3nm et 20 nm, une hauteur correspondant à la hauteur de la grille sacrificielle, et une dimension latérale adaptée aux besoins.

Sur l'exemple des figures 1 et 2, les première à troisième structures 100, 200, 300 comportent chacune trois premiers nano-objets 101, 201, 301 chacun en contact avec deux deuxièmes nano-objets 102, 202, 302 : on a donc quatre deuxièmes nano-objets 102, 202, 302 dans chacune des première, deuxième et troisième structures 100, 200, 300. Plus particulièrement, chaque structure est en fait un empilement de premier(s) et deuxièmes nano-objets. En ce sens, on dit que chacune des première à troisième structures 100, 200, 300 peut comporter une alternance de premiers nano-objets et de deuxièmes nano-objets. Notamment, chaque premier nano-objet 101 de la première structure 100 est situé dans l'alignement d'un des premiers nano-objets 201 de la deuxième structure 200 et d'un des premiers nano-objets 301 de la troisième structure 300, et chaque deuxième nano-objet 102 de la première structure 100 est situé dans l'alignement d'un des deuxièmes nano-objets 202 de la deuxième structure 200 et d'un des deuxièmes nano-objets 302 de la troisième structure 300. Autrement dit, chaque premier nano-objet 101 de la première structure 100 s'étend selon un axe commun avec un premier nano-objet 201 correspondant de la deuxième structure 200 et un premier nano-objet 301 correspondant de la troisième structure 300, et chaque deuxième nano-objet 102 de la première structure 100 s'étend selon un axe commun avec un deuxième nano-objet 202 correspondant de la deuxième structure 200 et avec un deuxième nano-objet 302 correspondant de la troisième structure 300.

De manière préférée, chaque premier nano-objet 101, 201, 301 est en matériau semi-conducteur, par exemple chaque premier nano-objet 101, 201, 301 est un nano-objet de, ou à base de, silicium. Par ailleurs, le cas échéant, chaque deuxième nano-objet 102, 202, 302 peut être en matériau semi-conducteur tel que par exemple du silicium-germanium, ou peut être à base de silicium-germanium. En fait, le matériau utilisé pour former les deuxièmes nano-objets 102, 202, 302 est choisi de sorte à présenter une sélectivité de gravure par rapport au matériau de chaque premier nano-objet 101, 201, 301. Lorsque le matériau de chaque premier nano-objet 101, 201, 301 est du silicium, et que le matériau de chaque deuxième nano-objet est du silicium-germanium de formulation Sh-ₖGeₖ avec k>0 et 1-k>0, ce dernier peut avoir une concentration en germanium telle que k est compris entre 0,15 et 0,6. Par la suite, SiGe correspond de manière générale à silicium-germanium sans impliquer que le silicium et le germanium soient en proportion égale, notamment le SiGe peut être selon la formulation Sh-ₖGeₖ donnée ci-dessus. L'avantage de ces deux matériaux précités est qu'il est possible de réaliser une gravure sélective des deuxièmes nano-objets 102, 202, 302 tout en conservant chaque premier nano-objet 101, 201, 301, cette gravure peut être une gravure sèche à base de HCl. Le SiGe en tant que matériau des deuxièmes nano-objets permet une mise en contrainte en tension des premiers nano-objets. Les deuxièmes nano-objets seront ensuite retirés dans une étape ultérieure. Cependant vu l'avantage que le SiGe procure vis-à-vis de sa sélectivité de gravure, il sera préférentiellement utilisé même si par la suite on cherche à mettre les premiers nano-objets en compression en utilisant des techniques de croissance d'électrodes particulières comme il le sera vu plus en détails ci-après.

Dans la présente description, lorsque le premier nano-objet 201 de la deuxième structure 200, et plus particulièrement sa partie 201c destinée à former la zone de canal associée, est contrainte en compression ou en tension, on entend que la compression, ou la tension, est selon l'axe de référence A_{ref} passant par les première et deuxième extrémités opposées 201a, 201b du premier nano-objet 201. Autrement dit, le premier nano-objet 201 a, soit tendance à se comprimer, soit tendance à s'étirer, selon l'axe de référence A_{ref} correspondant. La compression ou la tension de la zone de canal selon l'axe X (ou l'axe de référence A_{ref}) permet d'améliorer la mobilité des porteurs selon le type de transistor (pMOS ou nMOS).

De préférence, chaque premier nano-objet 101, 201, 301 présente une épaisseur comprise entre 4nm et 20nm. Par ailleurs, dans la configuration illustrée en figures 1 et 2, chaque premier nano-objet 101, 201, 301 présente préférentiellement une dimension, selon l'axe de référence A_{ref} passant par ses première et deuxième extrémités opposées 201a, 201b, comprise 11nm et 190nm. En particulier, selon l'axe de référence A_{ref}, le (et notamment chaque) premier nano-objet 201 correspondant comporte, sous chacun des premier et deuxième espaceurs 104a, 104b, une portion de dimension comprise entre 3nm et 20nm, et une portion de dimension comprise entre 5nm et 150nm entre les premier et deuxième espaceurs 104a, 104b. Pour finir, chaque premier nano-objet peut présenter une dimension latérale comprise entre 5nm et 100nm.

De préférence, les deuxièmes nano-objets 102, 202, 302 présentent chacun une épaisseur comprise entre 6nm et 20nm. Par ailleurs, dans la configuration illustrée en figures 1 et 2, les deuxièmes nano-objets 102, 202, 302 présentent chacun préférentiellement, parallèlement à l'axe de référence A_{ref} passant par le premier nano-objet 101, 201, 301 disposé entre lesdits deuxièmes nano-objets 102, 202, 302, une longueur comprise entre 11nm et 190nm. Pour finir, chaque deuxième nano-objet peut présenter une dimension latérale comprise entre 5nm et 100nm.

Ces dimensions des premier(s) et deuxièmes nano-objets sont tout particulièrement adaptées pour former un transistor.

Le substrat 1 évoqué précédemment peut être un substrat en, ou comportant du, silicium sur isolant, ou un substrat semi-conducteur massif (communément appelé « Bulk » selon la terminologique anglo-saxonne) par exemple en silicium.

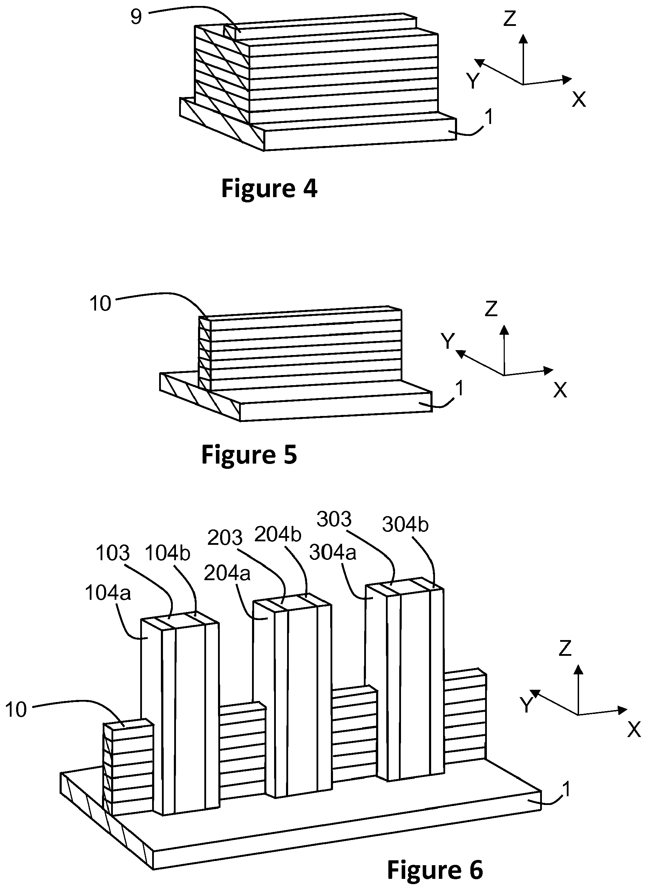

Pour former les première à troisième structures à fournir évoquées précédemment, et donc, le cas échéant, les empilements de premiers et deuxièmes nano-objets, il est possible de réaliser tout d'abord, comme illustré en figure 3, un empilement de couches semi-conductrices sur le substrat 1, formées par exemple par épitaxie. Cet empilement de couches semi-conductrices est formé par une alternance de couches 2, 3, 4, 5, en matériau destiné à former les deuxièmes nano-objets et de couches 6, 7, 8 en matériau destiné à former les premiers nano-objets. Les couches 6, 7, 8 en matériau destiné à former les premiers nano-objets sont de préférence telles que leur paramètre de maille correspond à un état relaxé dudit matériau. Les couches 2, 3, 4, 5 en matériau destiné à former les deuxièmes nano-objets sont notamment contraintes par adaptation de leur paramètre de maille à celui des couches 6, 7, 8 en matériau destiné à former les premiers nano-objets et à celui du substrat 1. Chacune des couches 2 à 8 présente une épaisseur adaptée au nano-objet qu'elle permet de former. Les couches 2, 3, 4, 5 destinées à former les deuxièmes nano-objets présentent chacune une épaisseur restant notamment inférieure à l'épaisseur critique au-delà de laquelle la couche concernée aurait tendance à se relaxer. Cet empilement de couches formé sur le substrat 1 peut ensuite être gravé (figures 4 et 5) selon un masquage, par exemple en utilisant un masque dur 9. La gravure de l'empilement de couches peut être une gravure sèche réalisée de manière isotrope (c'est-à-dire verticale). Au terme de l'étape de gravure de l'empilement de couches, et après retrait du masque dur 9, il est obtenu un empilement d'éléments allongés 10 tels qu'illustré en figure 5 au-dessus du substrat 1.

Si un substrat utilisé pour former l'empilement d'éléments allongés 10 est en SiGe sur isolant, l'empilement de couches formées par épitaxie est notamment réalisé à partir d'une couche du substrat comportant du SiGe obtenue par exemple par des procédés de condensation de Ge connues de l'homme du métier. Cette couche en SiGe du substrat peut alors être utilisée pour former au moins un deuxième nano-objet en SiGe sacrificiel en contact avec l'isolant qui formera alors le substrat 1 tel que fourni : la gravure permettant de former l'empilement d'éléments allongés 10 peut alors être réalisée jusqu'à l'isolant.

Lorsque le substrat est un substrat semi-conducteur de type « Bulk », par exemple en silicium, la gravure de l'empilement de couches peut se faire au moins jusqu'au substrat de silicium, ou peut se continuer dans le substrat de silicium de sorte à former une tranchée dans le substrat (ceci permettant par exemple d'obtenir une meilleure verticalité de l'empilement d'éléments allongés).

Il est possible de modifier le substrat 1 en poursuivant la gravure de l'empilement de couches dans le substrat 1, puis de combler la partie gravée du substrat par un oxyde, par exemple déposé par dépôt chimique en phase vapeur (CVD pour l'anglais « Chemical Vapor Déposition »). Un tel oxyde peut être un oxyde de silicium ou SiO₂. Un tel oxyde peut être de type TEOS. TEOS étant le sigle pour « Orthosilicate de tétraéthyle ». De cette manière, la base de l'empilement d'éléments allongés 10 peut être isolée électriquement.

Les éléments allongés 10 obtenus peuvent présenter une forme parallélépipédique, et pour chacun de ces éléments allongés l'épaisseur et la largeur correspondent, le cas échéant, soit à celles des premiers nano-objets souhaités, soit à celles des deuxièmes nano-objets souhaités.

Les grilles sacrificielles 103, 203, 303 peuvent être formées sur l'empilement d'éléments allongés 10 (figure 6) par exemple avec interposition d'un matériau de protection comme par exemple du SiO₂ d'épaisseur adaptée à la fonction de protection (par exemple quelques nanomètres). Chaque grille sacrificielle 103, 203, 303 aussi appelée « grille factice » (« dummy gâte » selon la terminologie anglo-saxonne) recouvre une partie correspondante du dessus de l'empilement d'éléments allongés 10, et recouvre des flancs latéraux d'une partie correspondante des éléments allongés 10.

Les premiers et deuxièmes espaceurs 104a, 104b, 204a, 204b, 304a, 304b sont ensuite formés de part et d'autre de chacune des grilles sacrificielles 103, 203, 303 (figure 6) de sorte à recouvrir une partie correspondante du dessus de l'empilement d'éléments allongés 10, ainsi qu'une partie correspondante des flancs latéraux de l'empilement d'éléments allongés 10. On dit qu'un couple de premier et deuxième espaceurs et la grille sacrificielle prise entre les espaceurs dudit couple recouvrent ainsi les nano-objets d'une structure correspondante.

Pour former les grilles sacrificielles 103, 203, 303 ainsi que les premiers et deuxièmes espaceurs 104a, 104b, 204a, 204b, 304a, 304b, il est utilisé des étapes de lithographie et de gravure qui ne portent pas préjudice à l'empilement d'éléments allongés 10 qui reste donc en place.

Après formation des grilles sacrificielles 103, 203, 303, et des premiers et deuxièmes espaceurs 104a, 104b, 204a, 204b, 304a, 304b, une gravure, par exemple une gravure sèche anisotrope, est ensuite réalisée pour retirer les parties non recouvertes des éléments allongés 10 de l'empilement d'où il résulte l'obtention des première à troisième structures 100, 200, 300 qui sont fournies avec le substrat 1 tel qu'illustré en figures 1 et 2.

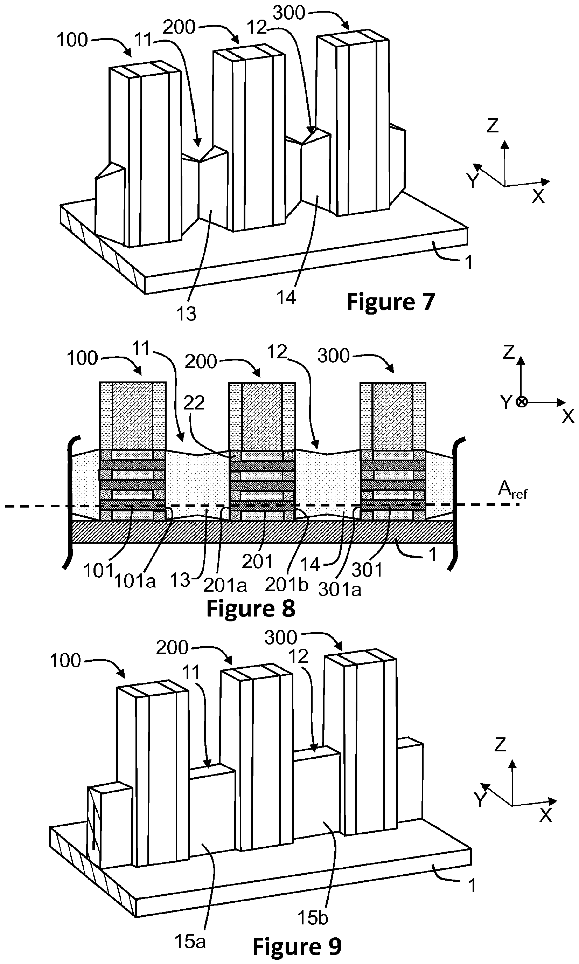

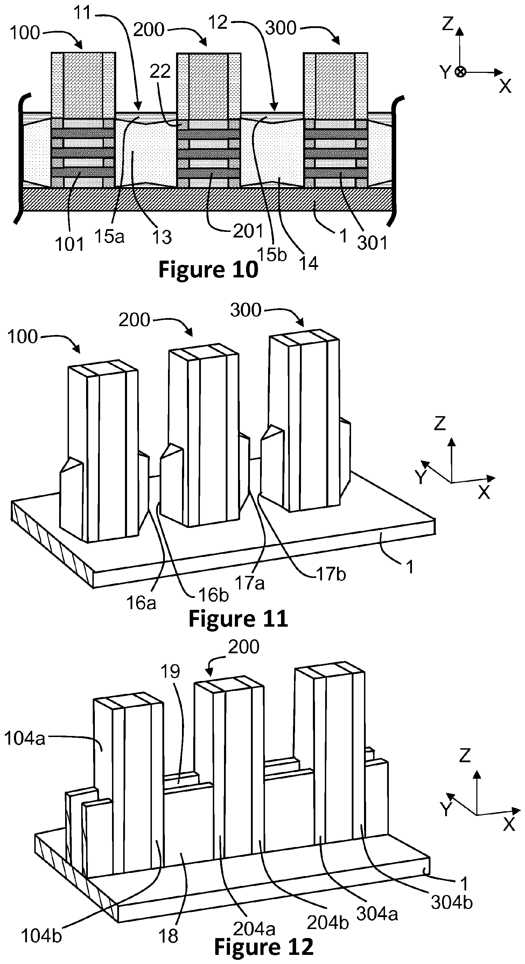

Après l'étape de fourniture du substrat 1, le procédé de fabrication peut comporter une étape de formation d'électrodes, notamment de première et deuxième électrodes, du transistor. Cette étape de formation d'électrodes est réalisée avant l'étape de retrait de la grille sacrificielle décrite précédemment. Aux figures 7 et 8, bien que la totalité des électrodes ne soit pas représentée, les références 11, 12 visent les électrodes qui sont dans la suite de la présente description notamment différentiées en première, et deuxième électrodes du transistor formé à partir de la deuxième structure 200. Le cas échéant les électrodes 11, 12 peuvent être respectivement une électrode de source et une électrode de drain, aussi appelées région de drain, ou région de source, dans le domaine. Plus particulièrement, l'étape de formation d'électrodes 11, 12 comporte une étape de croissance par épitaxie d'un premier matériau d'où il résulte l'obtention d'une première continuité de matière 13 en premier matériau reliant, selon l'axe de référence A_{ref}, la première extrémité 201a du premier nano-objet 201 de la deuxième structure 200 à la première structure 100, et l'obtention d'une deuxième continuité de matière 14 en premier matériau reliant, selon l'axe de référence A_{ref}, la deuxième extrémité 201b du premier nano-objet 201 de la deuxième structure 200 à la troisième structure 300. Dans la présente description, par « une continuité de matière reliant, selon l'axe de référence, deux choses entre elles », on entend qu'une droite, incluse dans la continuité de matière et confondue avec une partie longitudinale de l'axe de référence, relie ces deux choses. Les première et deuxième extrémités 201a, 201b du premier nano-objet 201 sont orientées respectivement vers la première structure 100 et vers la troisième structure 300 de sorte que les première et deuxième continuités de matière 13, 14 relient, selon l'axe de référence, le premier nano-objet 201 aux première et troisième structures 100, 300. Ainsi, au moins une portion de la première continuité de matière 13 est formée, selon l'axe de référence A_{ref}, dans le prolongement du premier nano-objet 201 pour relier sa première extrémité 201a à la première structure 100. Par ailleurs, au moins une portion de la deuxième continuité de matière 14 est formée, selon l'axe de référence A_{ref}, dans le prolongement du premier nano-objet 201 pour relier sa deuxième extrémité 201b à la troisième structure 300. Ces deux continuités de matière 13, 14 permettent d'ancrer la deuxième structure 200 aux première et troisième structures 100, 300. L'étape de croissance par épitaxie du premier matériau est notamment telle que la croissance est réalisée à partir d'au moins le premier nano-objet 201 de la deuxième structure 200 et à partir de portions des première et troisième structures 100, 300, ou plus particulièrement depuis les empilements de nano-objets des première, deuxième et troisième structures 100, 200, 300. Ces portions des première et troisième structures 100, 300 sont notamment chacune orientée vers le premier nano-objet 201 de la deuxième structure 200, et sont notamment chacune formée respectivement par une extrémité 101a du premier nano-objet 101 de la première structure 100 et par une extrémité 301a du premier nano-objet 301 de la troisième structure 300 (figure 8). En particulier, l'axe de référence A_{ref} passant par les première et deuxième extrémités 201a, 201b du premier nano-objet 201 correspondant de la deuxième structure 200 passe aussi par la portion de la première structure 100, et par la portion de la troisième structure 300 évoquées ci-dessus. Ces ancrages présentent l'avantage d'obtenir une base mécanique solide que l'on va utiliser par la suite pour induire, grâce à une nouvelle épitaxie, la contrainte mécanique au sein du premier nano-objet 201 de la deuxième structure 200. On comprend alors que l'étape de formation d'électrodes comporte aussi une étape de croissance par épitaxie d'un deuxième matériau (figures 9 et 10), à partir du (c'est-à-dire notamment depuis le, ou sur le) premier matériau des première et deuxième continuités de matière 13, 14. Le deuxième matériau a un paramètre de maille différent du (c'est-à-dire strictement supérieur ou strictement inférieur au) paramètre de maille du premier matériau des première et deuxième continuité de matière 13, 14 d'où il résulte que le deuxième matériau, déposé par croissance par épitaxie sur les première et deuxième continuités de matière 13, 14, est contraint. En fait, il résulte de la croissance du deuxième matériau la formation de parties 15a, 15b des première et deuxième électrodes 11, 12 respectivement sur la première continuité de matière 13 et sur la deuxième continuité de matière 14 de sorte que le deuxième matériau des parties 15a, 15b soit contraint par le premier matériau des première et deuxième continuités de matière 13, 14. Par ailleurs, il résulte de l'étape de croissance par épitaxie du deuxième matériau l'introduction d'une contrainte souhaitée au sein du, c'est-à-dire une mise en contrainte du, premier nano-objet 201 de la deuxième structure 200. Ainsi, il résulte de l'étape de croissance par épitaxie du deuxième matériau que la zone de canal est contrainte (on dit aussi que la partie 201c du premier nano-objet 201 est contrainte). En fait, c'est la croissance par épitaxie de deux matériaux entre les première et deuxième structures 100, 200 ainsi qu'entre les deuxième et troisième structures 200, 300 qui permet d'induire la contrainte mécanique axiale dans le premier nano-objet 201 de la deuxième structure 200 selon l'axe de référence A_{ref}.

On comprend de ce qui a été décrit ci-dessus que le deuxième matériau que l'on cherche à faire croître présente à l'état relaxé un paramètre de maille différent du paramètre de maille du premier matériau des première et deuxième continuités de matière 13, 14. Ainsi, lors de la croissance du deuxième matériau sur le premier matériau, le deuxième matériau adapte sa maille à celle du premier matériau des première et deuxième continuités de matière 13, 14, ceci permettant notamment d'induire la contrainte mécanique souhaitée au sein du premier nano-objet 201 de la deuxième structure, en particulier dans la partie du premier nano-objet destinée à former la zone de canal du transistor. Par « induire une contrainte mécanique », on entend ici une contrainte mécanique en tension ou en compression du premier nano-objet 201 de la deuxième structure 200 selon l'axe de référence, c'est-à-dire entre ses première et deuxième extrémités 201a, 201b. Cette contrainte est soit générée, soit obtenue par modification d'une contrainte initiale. Par ailleurs, la croissance du deuxième matériau peut être telle qu'elle applique des efforts sur le premier matériau de sorte à modifier la contrainte initiale du premier nano-objet 201 de la deuxième structure 200, par exemple en l'augmentant ou en la diminuant jusqu'à obtenir une contrainte contraire. La contrainte contraire de la contrainte en tension étant la contrainte en compression, et la contrainte contraire de la contrainte en compression étant la contrainte en tension. La croissance par épitaxie du premier matériau et la croissance par épitaxie du deuxième matériau sont tout particulièrement adaptées car le premier matériau va pouvoir croître au moins à partir (c'est-à-dire notamment au moins depuis) des première et deuxième extrémités 201a, 201b de chaque premier nano-objet 201, et le deuxième matériau va pouvoir croître à partir du (c'est-à-dire notamment sur le) premier matériau des première et deuxième continuités de matière 13, 14 de sorte à appliquer une force sur ce dernier qui va se traduire ensuite par une mise sous contrainte en compression ou en tension du premier nano-objet 201 de la deuxième structure 200.

Plus précisément, la croissance par épitaxie du premier matériau va permettre de former simultanément pour la deuxième structure 200 les première et deuxième continuités 13, 14 de matière qui forment alors des portions en premier matériau respectivement des première et deuxième électrodes 11, 12 (figures 7, 8, 10). En ce sens, la première continuité de matière 13 est située entre les première et deuxième structures 100, 200 et relie le, ou les premiers nano-objets 101 de la première structure 100 à le, ou les, premiers nano-objets 201 de la deuxième structure 200. Par ailleurs, la deuxième continuité de matière 14 peut relier le, ou les, premiers nano-objets 201 de la deuxième structure 200 à le, ou les, premiers nano-objets 301 de la troisième structure 300. En particulier, au terme de la croissance du premier matériau, la hauteur des première et deuxième continuités 13, 14 de matière peut correspondre à celle de l'empilement de nano-objets de la deuxième structure 200, la largeur des première et deuxième continuités de matière 13, 14 peut correspondre à celle de l'empilement de nano-objets.

Ensuite, la croissance par épitaxie du deuxième matériau permet de former simultanément les parties 15a, 15b en deuxième matériau respectivement des première et deuxième électrodes 11, 12 (figures 9 et 10). Au terme de la croissance du deuxième matériau, la première électrode 11 et la deuxième électrode 12 peuvent avoir chacune une hauteur au moins égale à celle de l'empilement de nano-objets de la deuxième structure 200, et une largeur au moins égale, ou strictement supérieure, à celle de l'empilement de nano-objets de la première structure 200.

En particulier, pour obtenir la contrainte en compression au sein du premier nano-objet 201 de la deuxième structure 200, le deuxième matériau présente, notamment dans son état relaxé, un paramètre de maille strictement supérieur au paramètre de maille du premier matériau des première et deuxième continuités de matière 13, 14. En particulier, pour induire une contrainte en tension au sein du premier nano-objet 201 de la deuxième structure 200, le deuxième matériau présente, notamment dans son état relaxé, un paramètre de maille strictement inférieur au paramètre de maille du premier matériau des première et deuxième continuités de matière 13, 14. On comprend que la contrainte vue au sein du premier nano-objet 201 de la deuxième structure 200 est dépendante des électrodes formées à partir des deux épitaxies. Par ailleurs, cette contrainte bien que présente à la fin de l'étape de croissance par épitaxie du deuxième matériau pourra s'exprimer plus effectivement au sein de la zone de canal après libération de la zone de canal, c'est-à-dire après gravure des deuxièmes nano-objets, notamment en SiGe, comme il le sera vu par la suite.

De manière générale, la croissance par épitaxie du deuxième matériau est réalisée sur les première et deuxième continuités de matière 13, 14 en premier matériau dont les contraintes selon l'axe X ne sont pas importantes, le premier matériau formant les première et deuxième continuités de matière 13, 14 est alors considéré comme étant relaxé.

Le premier matériau est notamment un semi-conducteur et le deuxième matériau est notamment un semi-conducteur. Le premier matériau peut être un semi-conducteur dopé en fonction de si l'on souhaite former un transistor nMOS ou pMOS, il en va de même pour le deuxième matériau. L'homme du métier sera à même de choisir le dopage adapté.

De manière générale, dans le but de former un transistor pMOS, le premier matériau, de préférence dopé, peut être du silicium, ou du silicium-germanium (c'est-à-dire un alliage silicium-germanium), et le deuxième matériau, de préférence dopé, peut être du silicium-germanium. La concentration ou pourcentage atomique en germanium au sein du deuxième matériau est supérieure à la concentration en germanium au sein du premier matériau lorsque ce dernier en comporte. Par « du silicium » ou « du silicium-germanium », on peut entendre « à base de silicium » ou « à base de silicium-germanium ». Notamment, le premier matériau (dopé ou non) peut être du Si(₁₋ₓ)Geₓ ou du Si, et le deuxième matériau (dopé ou non) peut être du Si(_{1-y})Ge_{y} avec x>0, y>0 et x étant strictement inférieur à y. Bien entendu, on a aussi 1-x>0 et 1-y>0. Le cas échéant, pour un transistor pMOS, le dopant peut être du bore. Ici, le dopage peut être réalisé par implantation ionique ou par épitaxie.

Dans la présente description, par « dopé » on entend un dopage intentionnel pour modifier les propriétés électriques d'un composé.

Dans le but de former un transistor nMOS, la croissance par épitaxie du deuxième matériau, de part et d'autre de chaque premier nano-objet 201 de la deuxième structure 200, à partir du premier matériau permet d'induire la contrainte. Selon une autre formulation la croissance par épitaxie du deuxième matériau permet, le cas échéant, de renforcer la contrainte, en tension de chaque premier nano-objet 201 de la deuxième structure 200. Dans le cadre de la fabrication d'un transistor nMOS, le premier matériau peut être du silicium et le deuxième matériau du carbure de silicium dopé par du phosphore ou dopé par de l'arsenic.

Lorsque le premier matériau, de préférence dopé, est du silicium-germanium et que le deuxième matériau, de préférence dopé, est du silicium germanium, il est possible de distinguer les deux cas suivants :
- le deuxième matériau présente un pourcentage atomique de germanium strictement supérieur au pourcentage atomique de germanium du premier matériau d'où il résulte une mise en compression de la zone de canal,
- le deuxième matériau présente un pourcentage atomique de germanium strictement inférieur au pourcentage atomique de germanium du premier matériau d'où il résulte une mise en tension de la zone de canal.

Selon un exemple où le premier matériau et le deuxième matériau comportent chacun du SiGe, le SiGe du deuxième matériau comporte de 30% at à 60% at de germanium et au moins 20% at de germanium en plus que le SiGe du premier matériau. Ici, le cas échéant, le dopage du SiGe (notamment du premier matériau et du deuxième matériau) peut être réalisé par du bore. « % at » correspond à un pourcentage atomique. De tels pourcentages atomiques permettent d'induire une contrainte satisfaisante en compression dans le premier nano-objet 201 de la deuxième structure 200. Selon cet exemple, on réalise un transistor pMOS.

Afin de permettre un ancrage adéquat de la deuxième structure 200 aux première et troisième structures 100, 300, l'étape de croissance par épitaxie peut être mise en oeuvreau moins depuis les première, deuxième et troisième structures 100, 200, 300.

Lorsque le substrat 1 est un substrat de semi-conducteur sur isolant électrique, et que les première à troisième structures 100, 200, 300 s'étendent depuis l'isolant, ou plus généralement que ces structures sont entourées par une surface isolante du substrat, la croissance, notamment sélective, par épitaxie du premier matériau n'est permise que depuis des zones des première à troisième structures 100, 200, 300, en particulier depuis au moins les première et deuxième extrémités de chaque premier nano-objet 101, 201, 301 issu des première à troisième structures 100, 200, 300, et le cas échéant des extrémités opposées des deuxièmes nano-objets si elles sont libres et donc accessibles. Autrement dit, de manière plus générale, le substrat 1 peut être tel qu'il présente, avant la mise en oeuvrede l'étape de croissance par épitaxie du premier matériau, une première zone libre 1a (figures 1 et 2) reliant la première structure 100 à la deuxième structure 200 et une deuxième zone libre 1b reliant la deuxième structure 200 à la troisième structure 300, les première et deuxième zones libres 1a, 1b étant en matériau diélectrique depuis lequel la croissance par épitaxie du premier matériau est inhibée : ceci s'applique tout particulièrement au premier mode de réalisation décrit ci-après et présente l'avantage de limiter la quantité de premier matériau au sein des première et deuxième continuités de matière.

Lorsque le substrat est un substrat massif, par exemple à base de silicium, la croissance par épitaxie du premier matériau peut se faire depuis le substrat et depuis des zones des première à troisième structures, en particulier depuis au moins les extrémités libres des premiers nano-objets. Autrement dit, de manière plus générale, l'étape croissance par épitaxie du premier matériau peut être telle que ladite croissance du premier matériau est aussi réalisée depuis le substrat, notamment depuis une première zone libre 1a du substrat située entre les première et deuxième structures 100, 200 (figures 1 et 2) et depuis une deuxième zone libre 1b du substrat 1 située entre les deuxième et troisième structures 200, 300 : ceci s'applique tout particulièrement aux deuxième et troisième modes de réalisation décrits ci-après pour remplir au mieux des espaces de confinements décrits ci-après. Ici, ces première et deuxième zones libres 1a, 1b sont notamment en silicium. L'avantage est ici d'obtenir une différence de paramètre de maille entre les premier et deuxième matériaux.

Selon un premier mode de réalisation illustré en figures 7 à 11, l'étape de croissance par épitaxie du premier matériau se fait depuis les première à troisième structures 100, 200, 300, notamment au moins à partir (c'est-à-dire notamment au moins depuis) des première et deuxième extrémités opposées des premiers nano-objets 101, 201, 301. Ainsi, l'étape de croissance par épitaxie du premier matériau se fait (c'est-à-dire est réalisée) de telle sorte que :
- entre les première et deuxième structures 100, 200, le premier matériau croît, d'une part, depuis la première structure 100 vers la deuxième structure 200, et, d'autre part, depuis la deuxième structure 200 vers la première structure 100 (à l'image de ce qui est représenté en figure 11) d'où il résulte la présence de deux fronts 16a, 16b de croissance entre les première et deuxième structures 100, 200, et
- entre les deuxième et troisième structures 200, 300 le premier matériau croît, d'une part, depuis la troisième structure 300 vers la deuxième structure 200, et, d'autre part, depuis la deuxième structure 200 vers la troisième structure 300 d'où il résulte la présence de deux fronts (figure 11) de croissance 17a, 17b entre les deuxième et troisième structures 200, 300.
Les fronts de croissance 16a, 16b, ainsi que les fronts de croissance 17a, 17b, vont se rapprocher jusqu'à arriver en contact (figures 7 et 8) pour former les première et deuxième continuités de matière 13, 14 évoquées précédemment. En particulier, selon ce premier mode de réalisation, l'étape de croissance par épitaxie du premier matériau est stoppée consécutivement, et de préférence dès, la mise en contact des fronts de croissance 16a, 16b entre les première et deuxième structures 100, 200, et des fronts de croissances 17a, 17b entre les deuxième et troisième structures 200, 300. L'avantage de stopper la croissance par épitaxie dès que les fronts de croissance se rejoignent est de pouvoir réaliser ensuite la deuxième épitaxie en faisant croître plus de deuxième matériau pour augmenter son volume et maximiser l'apport de contraintes dans chaque premier nano-objet 201 de la deuxième structure 200. De préférence, le substrat 1 est ici tel que les première à troisième structures 100, 200, 300 s'étendent depuis, c'est-à-dire sont formées sur, un isolant électrique du substrat 1 comme par exemple du SiO₂: on se retrouve alors dans un cas décrit ci-dessus où les première et deuxième zones libres 1a, 1b du substrat 1 sont en matériau diélectrique depuis lequel la croissance par épitaxie du premier matériau est inhibée. L'avantage d'inhiber la croissance du premier matériau depuis le substrat 1 est de limiter la quantité de premier matériau pour assurer ensuite un enrobage adapté du premier matériau par le deuxième matériau. Au terme de la croissance par épitaxie du premier matériau les première et deuxième continuités de matière 13, 14 peuvent présenter des facettes telles qu'illustrées en figure 7. En ce sens, la première continuité de matière 13 et la deuxième continuité de matière 14 peuvent présenter un amincissement à l'endroit où les fronts de croissance se sont rejoints. L'avantage de cette forme particulière des première et deuxième continuités de matière 13, 14 est que la croissance par épitaxie du deuxième matériau peut être initiée au plus proche de l'axe de référence A_{ref} (figure 8) passant par le premier nano-objet 201 de la deuxième structure 200, par ailleurs un autre avantage est d'avoir un volume plus important de deuxième matériau que le volume de premier matériau déposé lors de sa croissance par épitaxie afin d'optimiser la contrainte au sein du premier nano-objet 201 de la deuxième structure 200. En particulier, pour chacune des première et deuxième continuités de matière 13, 14, deux facettes latérales de ladite continuité de matière se présentent en biseau et se rejoignent entre les structures concernées. Concernant la première continuité de matière 13 de la première électrode 11, celle-ci comporte deux portions comportant chacune deux facettes latérales en biseau et convergentes en direction d'une jointure (formée à l'endroit où les deux fronts se sont rejoints) entre les deux portions de la première continuité de matière 13 de la première électrode 11, le même principe s'applique pour la deuxième électrode 12. Autrement dit, la première continuité de matière 13 de la première électrode 11 est plus fine à la jointure, la finesse étant mesurée dans une direction latérale orthogonale à l'axe de référence A_{ref} et à un vecteur normal au plan du substrat 1. L'avantage de cette forme est de permettre l'apport de deuxième matériau, pour former les parties 15a, 15b, de manière rapprochée à l'axe de référence A_{ref}, et d'avoir un volume plus important de deuxième matériau pour améliorer la contrainte induite dans ledit premier nano-objet.

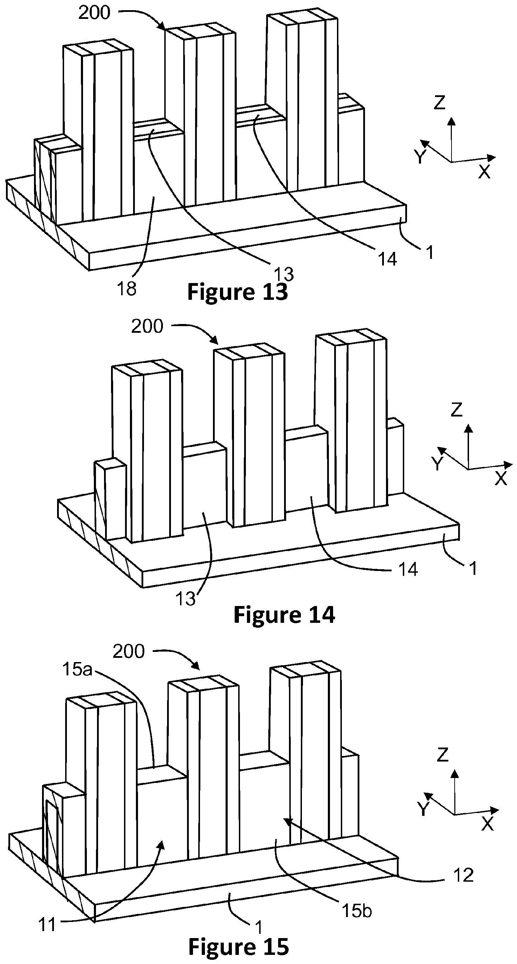

Selon un deuxième mode de réalisation illustré en figures 12 à 15, le procédé de fabrication peut comporter une étape de formation d'un masque de croissance 18 pour former des espaces de confinement 19 (figure 12) dans lesquels la croissance par épitaxie du premier matériau est réalisée (figure 13) pour former les première et deuxième continuités de matière 13, 14 en particulier en comblant ces espaces de confinement par du premier matériau. Le procédé de fabrication peut en outre comporter, après la mise en oeuvre de l'étape de croissance du premier matériau par épitaxie dans les espaces de confinement, une étape de retrait du masque de croissance 18 avant de mettre en oeuvre l'étape de croissance par épitaxie du deuxième matériau. Ces espaces de confinement 19 permettent de contrôler au mieux les formes et les dimensions souhaitées des première et deuxième continuités de matière 13, 14 afin d'optimiser la contrainte induite dans le premier nano-objet de la deuxième structure 200 consécutivement à la croissance du deuxième matériau pour former les parties 15a, 15b en deuxième matériau des première et deuxième électrodes 11, 12 (figure 15). De préférence, le masque de croissance 18 est formé simultanément avec les premiers et deuxièmes espaceurs 104a, 104b, 204a, 204b, 304a, 304b (figure 12) évoqués précédemment pour limiter le nombre d'étapes technologiques du procédé de fabrication.

Selon ce deuxième mode de réalisation, le premier matériau peut croître lors de l'épitaxie liée à l'étape de croissance par épitaxie du premier matériau depuis les zones libres 1a, 1b du substrat 1 évoquée précédemment. Dans ce cas, la croissance du premier matériau peut se faire dans les espaces de confinement 19 à partir du substrat 1 et des première à troisième structures 100, 200, 300 comme cela a été évoqué précédemment. La croissance depuis le substrat 1, notamment au fond des espaces de confinement 19, permet de remplir de manière homogène les espaces de confinement 19. Notamment, avant de former le masque de croissance 18, les zones libres 1a ,1b peuvent avoir été obtenues par gravure des éléments allongés 10 évoqués ci-avant, et ces zones libres 1a, 1b peuvent être entourées par l'oxyde comblant des parties retirées du substrat 1 lors de la gravure de l'empilement de couches semi-conductrices : en ce sens préférentiellement seules les zones libres du substrat 1 situées entre deux structures adjacentes et la, ou les, zones de canal sont en un matériau tel que le silicium autorisant la croissance par épitaxie du premier matériau.

Après croissance du premier matériau (figure 13), le procédé de fabrication comporte, selon le deuxième mode de réalisation, une étape de retrait du masque de croissance 18 (figure 14) avant de mettre en oeuvrel'étape de croissance par épitaxie du deuxième matériau comme illustré en figure 15 où ce dernier vient recouvrir les première et deuxième continuités de matière 13, 14 pour former les parties 15a, 15b des première et deuxième électrodes 11, 12 en deuxième matériau. Cette étape de retrait du masque 18 permet notamment de rendre accessible les flancs des première et deuxième continuité de matière 13, 14 en vue d'améliorer la contrainte induite dans le premier nano-objet de la deuxième structure 200 par la croissance du deuxième matériau.

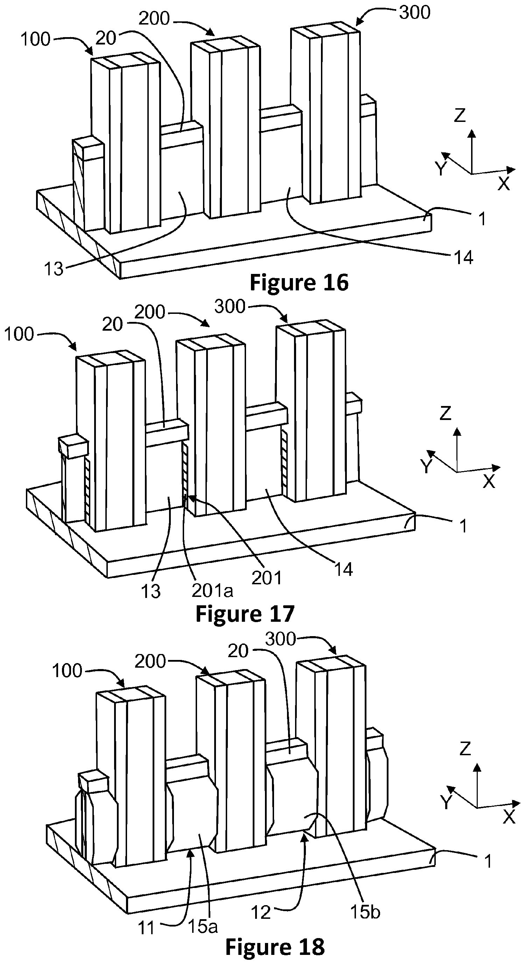

Selon un troisième mode de réalisation, illustré en figure 16 à 19, l'étape de formation d'électrodes peut comporter une étape de formation de protections 20 agencées dans le prolongement des première et deuxième continuités de matière 13, 14 de sorte que les première et deuxième continuités de matière 13, 14 sont chacune agencée entre l'une des protections 20 et le substrat 1. Les protections 20, aussi appelées capots ou masques, sont en contact respectivement avec les première et deuxième continuités de matière 13, 14. Ces protections 20 permettent ensuite d'autoriser un affinage (figure 17) latéral des première et deuxième continuités de matière 13, 14 par gravure. Autrement dit, l'étape de formation d'électrodes comporte aussi, après l'étape de formation de protections 20, une étape de gravure latérale du premier matériau de sorte à affiner les première et deuxième continuités de matière 13, 14 avant de mettre en oeuvrel'étape de croissance par épitaxie du deuxième matériau. Par « affinage » ou « affiner », on entend dans la présente description rendre plus fin, c'est à dire diminuer la largeur, selon l'axe Y (c'est-à-dire selon une direction orthogonale à l'axe de référence et à un vecteur normal à la face du substrat 1 où sont formées les première à troisième structures 100, 200, 300 ou plus particulièrement les première et deuxième continuités de matière 13, 14). Plus l'affinage est important, plus le volume occupé par le deuxième matériau pourra être important entre deux structures adjacentes, ce qui permettra d'améliorer la contrainte en compression ou en tension de chaque premier nano-objet 201 de la deuxième structure 200. De préférence, ce troisième mode de réalisation peut être combinée avec le deuxième mode de réalisation dans le sens où les protections 20 peuvent être réalisées à partir de la configuration illustrée en figure 14, c'est-à-dire après l'étape de retrait du masque de croissance 18 évoqué ci-avant et avant la croissance par épitaxie du deuxième matériau : ceci présente l'avantage d'obtenir une géométrie adaptée à la croissance souhaitée du deuxième matériau. L'affinage peut être réalisé par gravure du premier matériau, par exemple une gravure latérale anisotrope en particulier sèche ou humide en fonction des matériaux présents et de la sélectivité nécessaire. De préférence, si la gravure latérale est telle qu'elle atteint le premier nano-objet de la deuxième structure 200, elle se fera en limitant la gravure de ce premier nano-objet sous le premier espaceur ou le deuxième espaceur correspondant.

Par ailleurs, au terme de l'étape de gravure latérale, la distance (selon l'axe Y) restante entre deux flancs latéraux opposés des première et deuxième continuités de matière 13, 14 peut être égale à la dimension des nano-objets selon l'axe Y, mais de préférence strictement inférieure à la dimension des nano-objets selon l'axe Y pour améliorer la mise sous contrainte souhaitée de chaque premier nano-objet 201 de la deuxième structure 200.

Ainsi, on comprend de ce qui a été décrit ci-dessus que l'étape de gravure latérale, et donc l'affinage des première et deuxième continuités de matière 13, 14 formant des portions des première et deuxième électrodes, peut être telle que cela permet de découvrir (voir notamment en figure 17) :
- de part et d'autre de la première continuité de matière 13, des portions de la première extrémité 201a du premier nano-objet 201 de la deuxième structure 200,
- de part et d'autre de la deuxième continuité de matière 14, des portions de la deuxième extrémité 201b du premier nano-objet 201 de la deuxième structure 200,
L'avantage de découvrir des portions des première et deuxième extrémités 201a, 201b du, ou de chaque, premier nano-objet 201 de la deuxième structure 200 est d'améliorer la contrainte en tension ou en compression au sein dudit premier nano-objet 201 consécutivement à la croissance du deuxième matériau. En particulier, la croissance du deuxième matériau se fait alors aussi à partir des portions découvertes des première et deuxième extrémités 201a, 201b du, ou de chaque, premier nano-objet 201 de la deuxième structure 200. L'étape de gravure latérale est notamment telle que chaque premier nano-objet 201 de la deuxième structure 200 comporte pour chacune de ses première et deuxième extrémités 201a, 201b deux portions découvertes correspondantes situées respectivement de part et d'autre de la continuité de matière. Lorsque l'on découvre des portions des nano-objets lors de l'étape de gravure latérale, cela peut aussi induire un enlèvement de matière des nano-objets découverts, ainsi en fonction du type de gravure, on évitera de graver le ou les premiers nano-objets 201 au-delà d'une distance correspondant à la dimension du premier, ou deuxième, espaceur 104a, 104b selon l'axe X. Bien entendu, si les première et deuxième continuité de matière 13, 14 sont en SiGe et le premier nano-objet 201 en Si, une gravure latérale sélective du SiGe permet d'éviter de graver le Si du premier nano-objet 201.

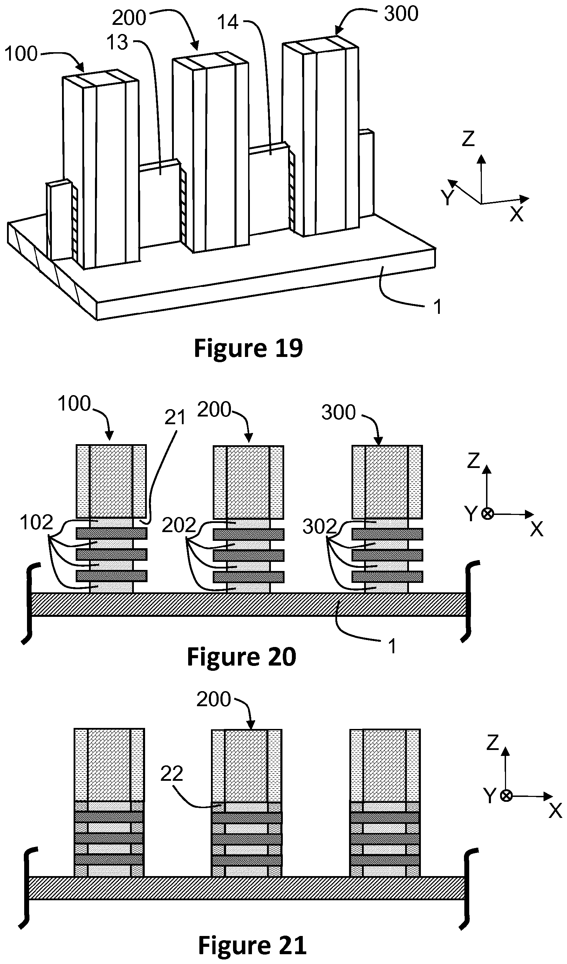

Par la suite, selon ce troisième mode de réalisation, après l'étape de gravure latérale, l'étape de croissance par épitaxie du deuxième matériau pour former les parties 15a, 15b des électrodes 11, 12 peut être réalisée alors que les protections 20 sont encore présentes. La figure 18 illustre justement la croissance par épitaxie du deuxième matériau qui est réalisée alors que les protections 20 sont présentes, d'où il résulte la formation des parties 15a, 15b des première et deuxième électrodes 11, 12. La conservation des protections 20 présente l'avantage de limiter le nombre d'étapes technologiques du procédé de fabrication. Alternativement, le procédé de fabrication peut comporter une étape de retrait des protections 20 de la figure 17 avant de réaliser l'étape de croissance par épitaxie du deuxième matériau : on se retrouve dans la configuration du type de la figure 19 où les sommets des première et deuxième continuités de matière 13, 14 sont accessibles pour la croissance du deuxième matériau. La croissance du deuxième matériau peut ensuite permettre de former les parties 15a, 15b des électrodes 11, 12 couvrant les première et deuxième continuités de matière comme illustré par exemple en figure 15. Le retrait des protections 20 peut être avantageux dans le sens où il permet au deuxième matériau d'occuper un plus grand volume et d'améliorer ainsi les contraintes imposées dans la zone de canal du transistor.

De manière générale, après l'étape de croissance par épitaxie du deuxième matériau, le procédé de fabrication peut comporter une étape de recuit. Cette étape de recuit a pour but de faire diffuser des atomes du deuxième matériau vers le premier matériau de sorte à augmenter la contrainte au sein du, ou de chaque, premier nano-objet 201 de la deuxième structure 200. En particulier, lorsque le premier matériau comporte du silicium, ou du silicium-germanium, et le deuxième matériau comporte du silicium-germanium, le procédé de fabrication comporte, après l'étape de croissance par épitaxie du deuxième matériau, l'étape de recuit telle qu'il en résulte la diffusion de germanium issu du deuxième matériau au sein du premier matériau, c'est-à-dire dans les première et deuxième continuités de matière 13, 14 en premier matériau. Cette diffusion de germanium est rendue possible lorsque le deuxième matériau comporte une concentration en germanium strictement supérieure à la concentration en germanium du premier matériau. Ceci permet d'augmenter la quantité de germanium au sein des première et deuxième continuités de matière 13, 14 pour en augmenter la contrainte en compression, et par voie de conséquence augmenter la contrainte en compression du premier nano-objet 201 de la deuxième structure 200. Une telle étape recuit peut être réalisée à une température comprise entre 800°C et 1000°C par exemple à une pression strictement inférieure à 1 torr, et éventuellement sous atmosphère inerte ou de H₂. L'étape de recuit est notamment mise en oeuvre après un retrait des deuxièmes nano-objets, notamment pour éviter que le germanium qu'ils comportent se diffuse dans la ou les zones de canal.

Selon une mise en oeuvre applicable à tout ce qui a été décrit ci-avant, des espaceurs internes destinés à séparer la future électrode de grille des première et deuxième électrodes du transistor sont formés pour améliorer les performances du transistor en diminuant les capacités parasites. La formation des espaceurs internes est connue en soi. Les espaceurs internes peuvent être en nitrure de silicium (SiN). Les espaceurs internes peuvent être formés avant ou après l'étape de formation d'électrodes décrite ci-avant, mais avant de déposer un matériau destiné à former une électrode de grille du transistor autour de la partie 201c du premier nano-objet 201 issu de la deuxième structure 200 tel qu'il le sera décrit ci-après. De préférence, et en particulier quand les deuxièmes nano-objets et les électrodes de source et de drain 11, 12 sont en SiGe, les espaceurs internes sont formés avant l'étape de formation d'électrodes pour éviter que le retrait du SiGe, issu des deuxièmes nano-objets et situé sous les premier et deuxième espaceurs, en vue de réaliser les espaceurs internes provoque aussi la gravure des électrodes en SiGe.

Dans l'exemple décrit ci-après, les espaceurs internes sont formés avant l'étape de formation d'électrodes. On part alors de la figure 1 où l'on voit que chacun des deuxièmes nano-objets 202 de la deuxième structure 200, et le cas échéant des deuxièmes nano-objets 102, 302 des première et troisième structures 100, 300, comporte deux parties d'extrémité disposées chacune sous l'un des premier ou deuxième espaceurs 104a, 104b, 204a, 204b, 304a, 304b correspondant. Autrement dit, chaque partie d'extrémité d'un deuxième nano-objet est couverte par l'un des premiers et deuxièmes espaceurs correspondant. Par ailleurs, le procédé de fabrication comporte comme illustré en figure 20, avant l'étape de formation d'électrodes, une étape de modification, notamment de raccourcissement, des deuxièmes nano-objets 102, 202, 302 par retrait (notamment par gravure sélective) de chacune des parties d'extrémité de chacun des deuxièmes nano-objets 102, 202, 302 de sorte à former des évidements 21. Sur la figure 20, comme on a douze deuxièmes nano-objets, on a la formation de vingt-quatre évidements 21 à partir des première à troisième structures 100, 200, 300. Le procédé de fabrication comporte en outre, avant l'étape de formation d'électrodes, une étape de formation d'espaceurs internes 22 dans les évidements 21 formés (figure 21). On dit alors que la deuxième structure 200 comporte des espaceurs internes 22. Notamment, l'étape de modification des deuxièmes nano-objets 102, 202, 302 est telle que chaque partie d'extrémité d'un deuxième nano-objet 102, 202, 302 correspond à un tronçon dudit deuxième nano-objet 102, 202, 302 de dimension selon l'axe X comprise entre 3nm et 20nm. Autrement dit, les portions des deuxièmes nano-objets situées sous les premiers et deuxièmes espaceurs sont remplacées par les espaceurs internes 22. Bien qu'aux figures 8 et 10 les première à troisième structures 100, 200, 300 comportent les espaceurs internes 22, ils pourraient ne pas être présents si ces derniers ne sont pas formés, ou formés après l'étape de formation d'électrodes.

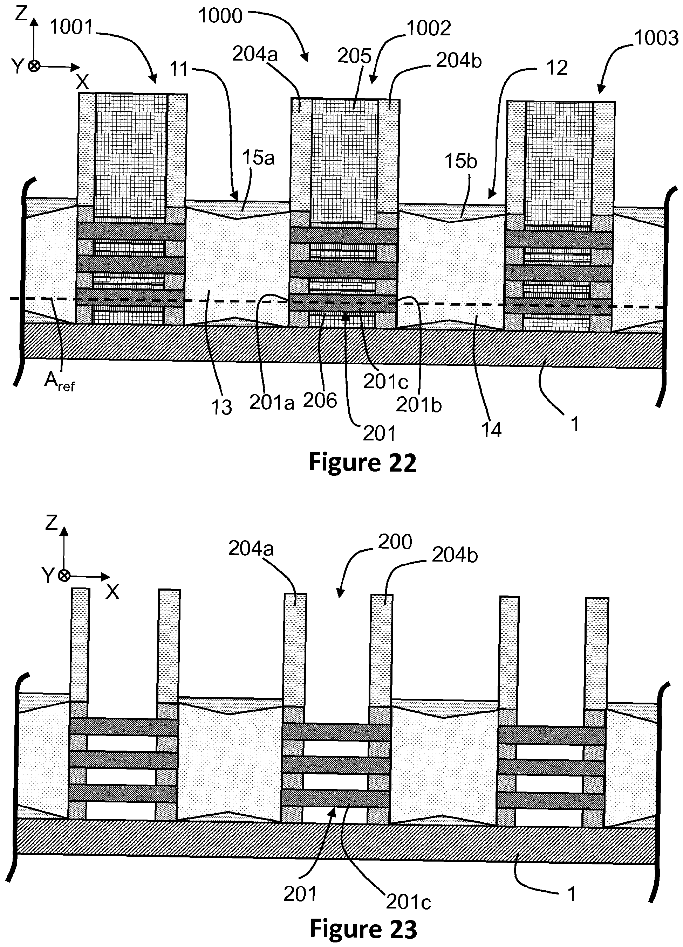

Enfin, de manière générale applicable à tout ce qui a été décrit ci-avant, le procédé de fabrication du transistor (figure 22) peut comprendre une étape de formation d'une électrode de grille 205 du transistor qui entoure, de préférence avec interposition d'un isolant de grille 206 la partie 201c du premier nano-objet 201 issue de la deuxième structure 200 et destinée à former la zone de canal du transistor. Notamment, la partie 201c de premier nano-objet 201 entourée par l'électrode de grille 205 correspondante est agencée entre les premier et deuxième espaceurs 204a, 204b en contact avec l'électrode de grille 205. L'électrode de grille 205 décrite ici est une électrode de grille enrobante. Par « interposition de l'isolant de grille 206 », on entend que l'électrode de grille 206 entoure un ou plusieurs premiers nano-objets 201 issu de la deuxième structure 200, au moins selon une partie dudit premier nano-objet 201 située entre ses première et deuxième extrémités 201a et 201b, mais n'est pas en contact direct avec le premier nano-objet 201.

Plus précisément, avant de former l'électrode de grille 205, le procédé de fabrication comporte une étape de retrait de la grille sacrificielle 203 de la deuxième structure 200 et une étape de gravure des deuxièmes nano-objets 202 de la deuxième structure 200 rendus accessibles par le retrait de la grille sacrificielle 203 pour libérer ladite, le cas échéant chaque, partie 201c du premier nano-objet 201 (figure 23) de la deuxième structure 200 destinée à former la zone de canal du transistor. Ensuite l'étape de formation de l'électrode de grille 205 permet de former ladite électrode de grille 205 entre les premier et deuxième espaceurs 204a, 204b issus de la deuxième structure 200.

L'isolant de grille 206 évoqué dans la présente description peut comporter un oxyde dit « interfacial » comme du SiO₂ déposé sur le premier nano-objet 201 de la deuxième structure 200, l'épaisseur déposée de l'oxyde peut aller d'une épaisseur de couche atomique dudit oxyde à 2nm, combiné à un matériau dit « High-k » pour matériau à constante diélectrique k élevée comme par exemple du HfO₂ déposé selon une épaisseur généralement comprise entre 1nm et 2nm. Le SiO₂ est alors intercalé entre le premier nano-objet 201 correspondant et le matériau dit « High-k ».

Le matériau d'électrode de grille peut être du TiN dont déposé selon une épaisseur par exemple de 5nm. L'homme du métier pourra aussi utiliser d'autres types de matériaux adaptés.

On comprend de ce qui a été décrit précédemment, que l'invention est aussi relative à un dispositif électronique illustré en figure 22 et dont les avantages découlent de ceux décrits en relation avec le procédé de fabrication. Le dispositif électronique comporte ledit au moins un transistor 1000, le substrat 1 surmonté de première, deuxième et troisième éléments 1001, 1002, 1003, le deuxième élément 1002 étant agencé entre les premier et troisième éléments 200, 300, le deuxième élément 1002 comportant ledit au moins un nano-objet 201. Le transistor est muni de la zone de canal formée par la partie 201c du nano-objet 201, ledit nano-objet 201 comprenant des première et deuxième extrémités opposées 201a, 201b selon l'axe de référence A_{ref} passant par les première et deuxième extrémités 201a, 201b et de préférence par les premier et troisième éléments 1001, 1003. Par ailleurs, le dispositif électronique est tel que :
- la première extrémité 201a du nano-objet 201 est reliée au premier élément 1001 par la première électrode 11 du transistor, ladite première électrode 11 comportant :
   ∘ une première partie formant la première continuité de matière 13 entre ladite première extrémité 201a et le premier élément 1001,
   ∘ une deuxième partie 15a formée sur ladite première partie,
- la deuxième extrémité 201b du nano-objet 201 est reliée au troisième élément 1003 par la deuxième électrode 12 du transistor, ladite deuxième électrode 12 comportant :
   ∘ une première partie formant la deuxième continuité de matière 14 entre ladite deuxième extrémité 201b et le troisième élément 1003,
   ∘ une deuxième partie 15b formée sur ladite première partie ,
les premières parties des première et deuxième électrodes 11, 12 étant formées en premier matériau et les deuxième parties des première et deuxième électrodes 11, 13 étant formées en deuxième matériau, le paramètre de maille du deuxième matériau s'étant adapté à celui du premier matériau de sorte à induire une contrainte dans le nano-objet 201 selon l'axe de référence passant par les première et deuxième extrémités 201a, 201b du nano-objet 201.

Notamment, les premier à troisième éléments 1001, 1002, 1003 forment chacun une structure qui comporte des parties issues respectivement des première à troisième structures et qui n'ont pas été retirées au cours du procédé de fabrication. En particulier, de la structure initiale il peut rester le ou les premiers nano-objets, les premier et deuxième espaceurs, et le cas échéant les espaceurs internes.

On comprend de tout ce qui a été décrit ci-avant que l'on utilise judicieusement des électrodes, notamment de source et de drain pour induire une contrainte souhaitée dans un nano-objet dont une partie est destinée à former une zone de canal de transistor. Le fait que la contrainte vue par les premiers nano-objets soit induite par les électrodes de deux transistors permet d'améliorer le maintien de cette contrainte même après gravure des deuxièmes nano-objets.

L'homme du métier sera à même de choisir le type des première et deuxième électrodes. Par exemple, la première électrode peut être une électrode de source et la deuxième électrode une électrode de drain ou inversement.

Le procédé de fabrication peut aussi comporter une étape d'encapsulation des électrodes formées par les deux étapes de croissance par épitaxie avant de retirer/graver les grilles sacrificielles. Après formation de l'électrode de grille, des contacts peuvent être formés sur l'électrode de grille ainsi que les première et deuxième électrodes, le cas échéant après retrait partiel de l'encapsulation des électrodes.

On comprend aussi de ce qui a été décrit ci-dessus que le procédé de fabrication décrit ci-avant peut aussi permettre de fabriquer une pluralité de transistors. Dans ce cas, l'étape de fourniture du substrat surmonté des première à troisième structures est telle que chacune des première à troisième structures comporte au moins un premier nano-objet situé à distance du substrat, une partie du premier nano-objet de la première structure étant destinée à former une zone de canal d'un premier transistor, la partie du premier nano-objet de la deuxième structure étant destinée à former une zone de canal d'un deuxième transistor, et une partie du premier nano-objet de la troisième structure étant destinée à former une zone de canal d'un troisième transistor.

## Revendications

1. Procédé de fabrication d'au moins un transistor à effet de champ, **caractérisé en ce qu'**il comporte :
- une étape de fourniture d'un substrat (1) surmonté de première, deuxième et troisième structures (100, 200, 300), la deuxième structure (200) étant agencée entre les première et troisième structures (100, 300), la deuxième structure (200) comprenant au moins un premier nano-objet (201) situé à distance du substrat (1), une partie (201c) du premier nano-objet (201) de la deuxième structure (200) étant destinée à former une zone de canal du transistor, le premier nano-objet (201) comportant des première et deuxième extrémités (201a, 201b) opposées selon un axe de référence (A_{ref}) passant par lesdites première et deuxième extrémités (201a, 201b),
- une étape de formation d'électrodes (11, 12) du transistor comprenant :
∘ une étape de croissance par épitaxie d'un premier matériau d'où il résulte l'obtention d'une première continuité de matière (13) en premier matériau reliant, selon l'axe de référence (A_{ref}), la première extrémité (201a) du premier nano-objet (201) de la deuxième structure (200) à la première structure (100), et l'obtention d'une deuxième continuité de matière (14) en premier matériau reliant, selon l'axe de référence (A_{ref}), la deuxième extrémité (201b) du premier nano-objet (201) de la deuxième structure (200) à la troisième structure (300),
∘ une étape de croissance par épitaxie d'un deuxième matériau, à partir du premier matériau des première et deuxième continuités de matière (13, 14), le deuxième matériau ayant un paramètre de maille différent du paramètre de maille du premier matériau des première et deuxième continuités de matière (13, 14) d'où il résulte que le deuxième matériau est contraint.

2. Procédé de fabrication selon la revendication 1, **caractérisé en ce que** l'étape de croissance par épitaxie du premier matériau est mise en oeuvreau moins depuis les première, deuxième et troisième structures (100, 200, 300).

3. Procédé de fabrication selon l'une quelconque des revendications précédentes, **caractérisé en ce qu'**il comporte une étape de formation d'un masque de croissance (18) pour former des espaces de confinement (19) dans lesquels la croissance par épitaxie du premier matériau est réalisée, et une étape de retrait du masque de croissance (18) avant de mettre en oeuvre l'étape de croissance par épitaxie du deuxième matériau.

4. Procédé de fabrication selon la revendication 2 et la revendication 3, **caractérisé en ce que** l'étape croissance par épitaxie du premier matériau est telle que ladite croissance du premier matériau est aussi réalisée depuis le substrat (1), notamment depuis une première zone libre (1a) du substrat (1) située entre les première et deuxième structures (100, 200) et depuis une deuxième zone libre (1b) du substrat (1) située entre les deuxième et troisième structures (200, 300).

5. Procédé de fabrication selon l'une quelconque des revendications précédentes, **caractérisé en ce que** l'étape de formation d'électrodes comporte :
- une étape de formation de protections (20) agencées dans le prolongement des première et deuxième continuités de matière (13, 14), les première et deuxième continuités de matière (13, 14) étant chacune agencée entre l'une des protections (20) et le substrat (1), puis
- une étape de gravure latérale du premier matériau de sorte à affiner les première et deuxième continuités de matière (13, 14) avant de mettre en oeuvre l'étape de croissance par épitaxie du deuxième matériau.

6. Procédé de fabrication selon la revendication 3 et la revendication 5, **caractérisé en ce que** l'étape de formation des protections (20) est réalisée après l'étape de retrait du masque de croissance (18) et avant l'étape de croissance par épitaxie du deuxième matériau.

7. Procédé de fabrication selon la revendication 5 ou la revendication 6, **caractérisé en ce que** l'étape de gravure latérale permet de découvrir :
- de part et d'autre de la première continuité de matière (13), des portions de la première extrémité (201a) du premier nano-objet (201) de la deuxième structure (200),
- de part et d'autre de la deuxième continuité de matière (14), des portions de la deuxième extrémité (201b) du premier nano-objet (201) de la deuxième structure (200).

8. Procédé de fabrication selon l'une quelconque des revendications 5 à 7, **caractérisé en ce qu'**après l'étape de gravure latérale :
- l'étape de croissance par épitaxie du deuxième matériau est réalisée alors que les protections (20) sont présentes, ou
- le procédé de fabrication comporte une étape de retrait des protections (20) avant de réaliser l'étape de croissance par épitaxie du deuxième matériau.

9. Procédé de fabrication selon la revendication 1, **caractérisé en ce que** l'étape de croissance par épitaxie du premier matériau se fait depuis les première, deuxième et troisième structures (100, 200, 300) et de telle sorte que :
- entre les première et deuxième structures (100, 200), le premier matériau croît d'une part, depuis la première structure (100) vers la deuxième structure (200), et, d'autre part, depuis la deuxième structure (200) vers la première structure (100) d'où il résulte la présence de deux fronts (16a, 16b) de croissance entre les première et deuxième structures (100, 200),
- entre les deuxième et troisième structures (200, 300), le premier matériau croît d'une part, depuis la troisième structure (300) vers la deuxième structure (200), et, d'autre part, depuis la deuxième structure (200) vers la troisième structure (300) d'où il résulte la présence de deux fronts (17a, 17b) de croissance entre les deuxième et troisième structures (200, 300),
l'étape de croissance par épitaxie du premier matériau étant stoppé consécutivement à la mise en contact des fronts de croissance (16a, 16b) entre les première et deuxième structures (100, 200) et des fronts de croissance (17a,17b) entre les deuxième et troisième structures (200, 300).

10. Procédé de fabrication selon la revendication précédente, **caractérisé en ce que** le substrat (1) est tel qu'il présente, avant la mise en oeuvre de l'étape de croissance par épitaxie du premier matériau, une première zone libre (1a) reliant la première structure (100) à la deuxième structure (200) et une deuxième zone libre (1b) reliant la deuxième structure (200) à la troisième structure (300), les première et deuxième zones libres (1a, 1b) étant en matériau diélectrique depuis lequel la croissance par épitaxie du premier matériau est inhibée.

11. Procédé de fabrication selon l'une quelconque des revendications précédentes, **caractérisé en ce que** le premier matériau, de préférence dopé, est du silicium ou du silicium-germanium, et le deuxième matériau, de préférence dopé, est du silicium-germanium.

12. Procédé de fabrication selon l'une quelconque des revendications 1 à 10, **caractérisé en ce que** le premier matériau est du Si(₁₋ₓ)Geₓ ou du Si, et le deuxième matériau est du Si(_{i-y})Ge_{y} , avec x>0, y>0 et x étant strictement inférieur à y.

13. Procédé de fabrication selon l'une quelconque des revendications précédentes, **caractérisé en ce qu'**il comporte, après l'étape de croissance par épitaxie du deuxième matériau, une étape de recuit.

14. Procédé de fabrication selon l'une quelconque des revendications précédentes, **caractérisé en ce qu'**il comporte une étape de formation d'une électrode de grille (205) du transistor qui entoure, de préférence avec interposition d'un isolant de grille (206), la partie (201c) du premier nano-objet (201) issue de la deuxième structure (200) et destinée à former la zone de canal du transistor.

15. Procédé de fabrication selon l'une quelconque des revendications précédentes, **caractérisé en ce que** l'étape de fourniture est telle que :
- la deuxième structure (200) comporte des deuxièmes nano-objets (202) sacrificiels, et **en ce que** le premier nano-objet (201) de la deuxième structure (200) est agencé entre, et en contact avec, deux deuxièmes nano-objets (202) de la deuxième structure (200) pour former un empilement de nano-objets, et
- une partie intermédiaire (Z1) dudit empilement de nano-objets est recouverte par une grille sacrificielle (203) située entre des premier et deuxième espaceurs (204a, 204b) recouvrant des parties d'extrémité (Z2, Z3) dudit empilement situées de part et d'autre de la partie intermédiaire (Z1), les première et deuxième extrémités (201a, 201b) opposées dudit premier nano-objet (201) de l'empilement de nano-objets étant accessibles au niveau des premier et deuxième espaceurs (204a, 204b).

16. Procédé de fabrication selon la revendication 14 et la revendication 15, **caractérisé en ce que**, avant de former l'électrode de grille (205) du transistor, le procédé de fabrication comporte une étape de retrait de la grille sacrificielle (203) et une étape de gravure des deuxièmes nano-objets (202) rendus accessibles par le retrait de la grille sacrificielle (203) pour libérer ladite partie (201c) du premier nano-objet (201) de la deuxième structure (200) destinée à former la zone de canal du transistor, ensuite l'étape de formation de l'électrode de grille (205) permet de former ladite électrode de grille (205) entre les premier et deuxième espaceurs (204a, 204b).

17. Dispositif électronique comportant au moins un transistor (1000), un substrat (1) surmonté de premier, deuxième et troisième éléments (1001, 1002, 1003), le deuxième élément (1002) étant agencé entre les premier et troisième éléments (1001, 1003), le deuxième élément (1002) comportant au moins un nano-objet (201) et le transistor étant muni d'une zone de canal formée par une partie (201c) dudit nano-objet (201), ledit nano-objet (201) comprenant des première et deuxième extrémités opposées (201a, 201b) selon un axe de référence (A_{ref}) passant par les première et deuxième extrémités (201a, 201b), ledit dispositif électronique étant **caractérisé en ce que** :
- la première extrémité (201a) du nano-objet (201) est reliée au premier élément (1001) par une première électrode (11) du transistor, ladite première électrode (11) comportant :
∘ une première partie formant une première continuité de matière (13) entre ladite première extrémité (201a) et le premier élément (1001),
∘ une deuxième partie (15a) formée sur ladite première partie,
- la deuxième extrémité (201b) du nano-objet (201) est reliée au troisième élément (1003) par une deuxième électrode (12) du transistor, ladite deuxième électrode (12) comportant :
∘ une première partie formant une deuxième continuité de matière (14) entre ladite deuxième extrémité (201b) et le troisième élément (1003),
∘ une deuxième partie (15b) formée sur ladite première partie,
les premières parties des première et deuxième électrodes (11, 12) étant formées en un premier matériau et les deuxième parties des première et deuxième électrodes étant formées en un deuxième matériau, le paramètre de maille du deuxième matériau s'étant adapté à celui du premier matériau de sorte à induire une contrainte dans le nano-objet (201) selon l'axe de référence.
